# EUROPEAN PATENT APPLICATION

(11) **EP 1 719 744 A1**
(43) Date of publication of application: **08.11.2006**
(21) Application number: 05704012.3
(22) Date of filing: 21.01.2005
(51) Int. Cl.: C04B 35/581, C04B 41/87

(54) **NON OXIDE CERAMIC HAVING OXIDE LAYER ON THE SURFACE THEREOF, METHOD FOR PRODUCTION THEREOF AND USE THEREOF**

(30) Priority: 23.01.2004 JP 2004015882; 03.02.2004 JP 2004026287; 09.02.2004 JP 2004031731; 07.07.2004 JP 2004199974
(71) Applicant: TOKUYAMA CORPORATION, Shunan-shi, Yamaguchi-ken 745-8648 (JP); THE CIRCLE FOR THE PROMOTION OF SCIENCE AND ENGINE, Meguro-ku Tokyo 1528550 (JP)
(72) Inventor: FUKUYAMA, H.; c/o I.M.R.A.M., Sendai-chi (JP); YONEDA, Takehiko; c/o TOKUYAMA CORPORATION, Yamaguchi 7458648 (JP); ARIYUKI, Masao; c/o TOKUYAMA CORPORATION, Yamaguchi 7458648 (JP); SUNAOSHI, Takeshi, Ibaraki 3120011 (JP); SATO, Hideki; c/o TOKUYAMA CORPORATION, Yamaguchi 7458648 (JP)
(74) Representative: Kador & Partner
(86) International application number: PCT/JP2005/000791
(87) International publication number: WO 2005/070851

(57) **Abstract**

[PROBLEM TO BE SOLVED] To provide a non-oxide ceramics having improved performances and functions by forming a high-quality oxide film on the surface of a non-oxide ceramics such as aluminum nitride.

[SOLUTION] The method for the formation of a non-oxide ceramics having on its surface an oxide layer formed by oxidizing the surface of a non-oxide ceramics is **characterized in that** the method comprises the steps of: (1) providing a non-oxide ceramics; (2) introducing the non-oxide ceramics into a furnace and then regulating the atmosphere within the furnace so as to have an oxidizing gas content of not more than 0.5 mmol in terms of total number of moles of the oxidizing gas per m3 of the inside of the furnace; (3) heating the non-oxide ceramics to a temperature at or above a temperature, which is 300°C below the oxidation start temperature of the non-oxide ceramics, while maintaining the low-oxidizing gas atmosphere and (4) brining the non-oxide ceramics heated in the step (3) into contact with an oxidizing gas and then holding the non-oxide ceramic at a temperature above the oxidation start temperature of the non-oxide ceramics to form an oxide layer, and that, in the step (4), until at least two min. elapses after the arrival of the temperature at or above the oxidation start temperature after the start of the contact between the non-oxide ceramics and the oxidizing gas, the pressure or partial pressure of the oxidizing gas is maintained at not more than 50 kPa.

## Description

### TECHNICAL FIELD

The present invention relates to a non-oxide ceramics having an oxide layer on its surface, comprising an oxide layer such as an aluminum oxide or silicon oxide layer on the surface of a non-oxide ceramics such as aluminum nitride or silicon nitride.
The present invention also relates to use of the non-oxide ceramics, particularly a cooling device and a plasma resistant member.

### BACKGROUND ART

Non-oxide ceramics such as aluminum nitride and silicon nitride have excellent features such as high thermal conductivity and high thermal shock resistance and have been used in various fields such as electronic circuit boards and engine members for automobiles.
Cooling devices for cooling exothermic elements such as semiconductor elements may be mentioned as one example of application of such non-oxide ceramics.

An increase in calorific value caused by souped-up semiconductor elements has led to an increasing demand for more efficient cooling of semiconductor elements. To meet this demand, a cooling device has been proposed. In this cooling device, a cooling jacket formed of a non-oxide ceramics having a high coefficient of thermal conductivity such as aluminum nitride is brought into thermal contact with the exothermic element, and water or an aqueous solution is passed as a cooling medium through a hollow provided within the cooling jacket to cool the exothermic element.

In the cooling device, however, upon contact of water with the surface of the non-oxide ceramics constituting the cooling jacket, hydrolysis occurs, disadvantageously resulting in significantly lowered mechanical strength. When aluminum nitride is used as the non-oxide ceramics, upon contact with water, aluminum hydroxide is formed on the surface, and, at the same time, ammonia is produced, disadvantageously leading to the progress of hydrolysis of aluminum nitride. In this case, although aluminum hydroxide formed on the surface of aluminum nitride suppresses the hydrolysis, a rise in pH caused by the production of ammonia disadvantageously dissolves this aluminum hydroxide.

In order to solve the above problem, a method for protecting a non-oxide ceramics by forming an oxide layer on the surface of the non-oxide ceramics has been proposed. Since, however, defects such as pores or microcracks, which reach the underlying non-oxide ceramics layer, exist in the oxide layer formed by the conventional method, the effect of protection attained by the oxide layer is unsatisfactory. In order to compensate for this effect, careful control of a cooling medium such as the removal of ionized materials contained in the cooling medium, should be carried out (see patent document 1).

However, a specialty device is necessary for removing ionized materials contained in the cooling mediums. This is an obstacle to the compactification of the whole cooling device and, at the same time, is disadvantageous from the viewpoint of cost.
Utilization of the non-oxide ceramics as a plasma resistant member has also been studied. Most of members for constituting a chamber in semiconductor or liquid crystal production apparatuses are formed of ceramics materials from the viewpoint of necessity of heat resistance and avoidance of wafer contamination. At the present time, alumina ceramics is mainly used as such ceramic materials. A tendency toward an increase in size of wafers has led to an increase in utilization of nitride ceramics having a high coefficient of thermal conductivity such as aluminum nitride from the viewpoint of uniform heat distribution of the wafer.

The production process of semiconductors or liquid crystals involves the step of treatment such as the formation of a thin film on a wafer such as a semiconductor wafer or a glass substrate for a liquid crystal, or etching. In these steps, in many cases, high-frequency waves such as microwaves are introduced into a chamber in the production apparatus in the presence of a halogen-type corrosive gas to generate plasma for the treatment of the wafer. Plasma of the halogen-type corrosive gas is highly corrosive. Further, when a nitride ceramics is used in the member for constituting the chamber, due to its high coefficient of thermal conductivity, the member is exposed to a high temperature.

As a result, a halide is produced on the surface of the member for constituting a chamber by reaction of the halogen-type corrosive gas with the ceramics. For example, when the halide is a chloride, due to its low melting point, the halide is sublimated at the wafer treatment temperature. Consequently, corrosion progresses, and particles causative of contamination occurs. When the corrosion further progresses, large concaves are formed and, thus, the stability of the shape of the surface of the member for constituting a chamber is deteriorated. As a result, when the member is, for example, a wafer holder, such problems to deteriorate performances of each member, for example, a deterioration in holding reliability, occur. The problem of the deterioration is particularly significant, for example, in wafer holders such as electrostatic chucks and susceptors, and window materials for high frequency wave introduction from plasma generation mechanisms, among the above members for constituting a chamber.

To improve the plasma resistance of the member for constituting a chamber formed of a nitride ceramics, various methods have hitherto been proposed. For example, a method in which aluminum nitride is heated in an oxidizing atmosphere such as the air to form an aluminum oxide layer on the surface of the aluminum nitride, is known as an effective method among such proposed methods known in the art (see patent document 2).
When the oxide layer is formed on the surface of the nitride ceramics by the conventional method, the formed oxide layer has low densiness and has a number of cracks which are relatively large in width and are broadly branched. In the nitride ceramics having the oxide layer on its surface, the effect of improving the plasma resistance is unsatisfactory, and, even when this nitride ceramics is used as a member for constituting a chamber, there is still room for improvement in the above-described various problems.

In the above non-oxide ceramics, in order to further enhance the above features or to compensate for the drawback, an oxide layer is formed on the surface of the non-oxide ceramics. In addition to the above technique, for example, regarding aluminum nitride, a method for forming an aluminum oxide layer on the surface of aluminum nitride is known for improving the adhesion between the aluminum nitride and a metal layer in the use of aluminum nitride as a circuit board, or for improving resistance in washing the material with an alkaline solution or water resistance. In this method, a sintered aluminum nitride substrate is heated in an oxidizing atmosphere such as the air to form an aluminum nitride layer on the surface of aluminum nitride (see patent documents 3 to 5 and non-patent document 1). On the other hand, regarding silicon nitride, a method for enhancing the strength of a member formed of a sintered silicon nitride is known. In this method, the surface of the member is oxidized to form a cristobalite-containing layer (see patent document 6).

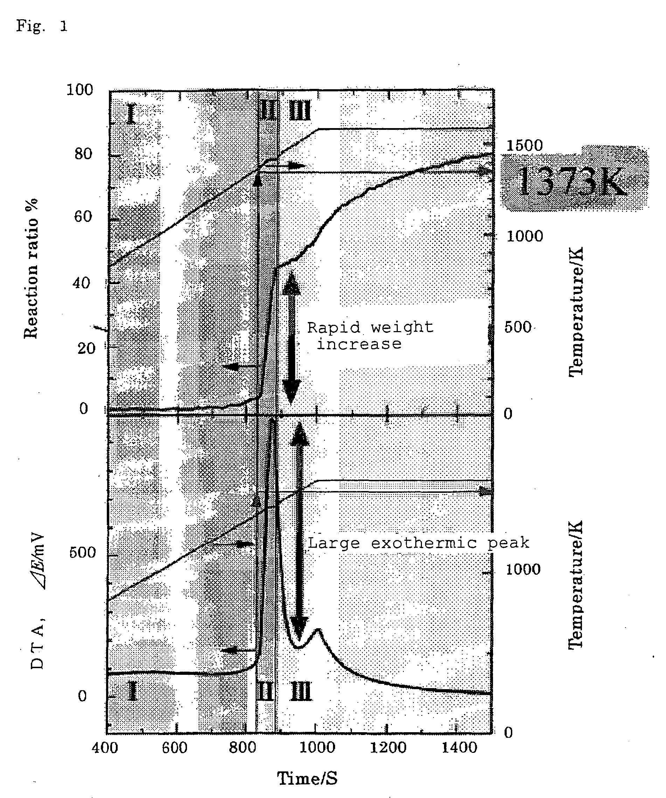

When an oxide film is formed on the surface of a non-oxide ceramics such as aluminum nitride, which is a typical nitride ceramics, by the conventional method as described above, a number of cracks, which has relatively large width and many branches, are formed in the oxide film thus obtained. Thus, the realization of the contemplated effect attained by the formation of the oxide film, that is, improved properties and enhanced function, is unsatisfactory.
The present inventors have considered that, in order to form a good oxide film on the surface of the non-oxide ceramics, they should find out an oxidation mechanism of the non-oxide ceramics. To this end, studies for elucidating the oxidation mechanism have been made using an aluminum nitride powder. As a result, it has been found that oxidation caused upon heating of the aluminum nitride powder in an oxygen gas proceeds through three stages as shown in Fig. 1. Specifically, Fig. 1 shows a change in reaction ratio with the elapse of time in an experiment where an aluminum nitride powder is heated in an oxygen atmosphere at a temperature rise rate of 75°C/min. In a graph in the upper part, the time (sec) is plotted as abscissa against the reaction ratio (%) measured by a thermogravimetric analysis and the temperature (K) corresponding to the temperature rise pattern as ordinate. In a graph in the lower part, the time (sec) is plotted as abscissa against DTA (ΔE/mV) showing calorific value measured by a differential thermal analysis and the temperature (K) corresponding to the temperature rise pattern as ordinate. The graphs in Fig. 1 can be divided into three stages of I to III. Stage I is a stage corresponding to a period in which aluminum nitride is heated from room temperature to 1100°C (1373 K). What takes place in this stage is only the dissolution of oxygen in aluminum nitride to form a solid solution, and, in this state, oxidation hardly occurs. In the stage II where the temperature reached about 1100°C, the oxygen in the solid solution form is reacted at a time and consequently is converted to A1203 (α-alumina), whereby a rapid weight increase and significant heat generation take place. In the stage III which is a stage after the rapid reaction has been tailed off, the reaction proceeds slowly in accordance with an oxygen diffusion controlled manner.

From the above oxidation mechanism, it has been found that, in order to form a dense oxide film on aluminum nitride, a method is effective in which aluminum nitride is heated in nitrogen to 1100°C while avoiding the dissolution of oxygen in a solid solution form and, in this state, the atmosphere is replaced by oxygen for oxidation, and that, when this method is adopted, the oxide film can be formed without a substantial change in surface state of the aluminum nitride powder (see non-patent document 2).
Patent document 1: Japanese Patent Laid-Open No. 150752/2000
Patent document 2: Japanese Patent Laid-Open No. 232409/1997
Patent document 3: Japanese Patent Laid-Open No. 152384/1998
Patent document 4: Japanese Patent Laid-Open No. 116071/1994
Patent document 5: Japanese Patent Laid-Open No. 123071/1987
Patent document 6: Japanese Patent Laid-Open No. 252388/1987 Non-patent document 1: Petra Kluge-Weiss and Jens Gobrecht, "DIRECTRY BONDED COPPER METALLIZATION OF AIN SUBSTRATES FOR POWER HYBRIDS", Materials Research Society, Symp. Proc., vol. 40, p. 399 to 404, 1985
Non-patent document 2: Hiroyuki Fukuyama et al., Proc. SIGEN SOZAI GAKKAI, p. 351 to 352 (23 September, 2002)

### DISCLOSURE OF THE INVENTION

### PROBLEMS TO BE SOLVED BY THE INVENTION

Further, some members of the present inventors have confirmed that, also when the above-described new oxidation process, that is, a process which comprises heating an aluminum nitride shaped product in an oxidizing gas-free atmosphere until the temperature reaches at which an oxidation reaction of aluminum nitride starts rapidly (a reaction start temperature) and, upon arrival at the reaction start temperature, bringing the aluminum nitride shaped product into contact with an oxidizing gas to oxidize the aluminum nitride shaped product (hereinafter also referred to simply as "new oxidation process"), is applied to a shaped product, rather than powder, of aluminum nitride, the above-described characteristic crack-free oxide film can be provided, and the resultant aluminum nitride shaped product having the oxide film has high water resistance and chemical resistance (Japanese Patent Laid-Open No. 91319/2004).

The reason why the above excellent effect can be attained is as follows. In the conventional oxidation process, oxygen is dissolved as a solid solution in aluminum nitride in the course of raising temperature, and, when the base material temperature reaches the reaction start temperature of the oxidation reaction, the oxygen in the solid solution form is reacted rapidly, resulting in the occurrence of cracks as described above in the oxide layer due to rapid occurrence of stress attributable, for example, to a difference in lattice constant between the underlying material and the oxide layer. On the other hand, in the new oxidation process, dissolution of oxygen does not take place in the course of raising temperature, and the oxidation reaction of the base material starts after when the temperature reaches the reaction start temperature and the base material is brought into contact with oxygen. In this case, since the reaction proceeds gradually in accordance with an oxygen diffusion-controlled manner, the above cracking does not take place. In the formation of the oxide film by this new oxidation process, when the thickness of the formed film is large, cracking sometimes takes place. The cracks in this case have a small width, and the degree of branching is also small. Further, the number of cracks(the number of cracks per unit area) is much smaller than the number of cracks in the conventional technique.

The "aluminum nitride shaped product having an oxide film on its surface" produced by the above new oxidation process was subjected to various tests from the viewpoint of applying the shaped product to members for cooling systems and to plasma-resistant members. As a result, it was found that, after a heat cycle test, the oxide film is occasionally peeled off.
The present inventors have considered that the above problem is derived from the presence of any defect in the interface between the aluminum nitride shaped product and the oxide film. That is, unlike the case where an oxide film is formed on the surface of each particle of an aluminum nitride powder, for example, when a shaped product such as a substrate is oxidized, since an oxide film is formed on the whole area of a continuous large-area surface, upon the heat cycle test, large stress is produced by a strain attributable to a difference in the coefficient of thermal expansion between the substrate and the oxide film. The present inventors have considered that, in this case, when a defect is present around the interface of the substrate and the oxide film, destruction proceeds with the defect serving as an origin of destruction, resulting in film separation. Further, the present inventors considered that, when an oxide film can be ideally formed without forming such defect, this problem can be solved, and they have studied such methods.

Accordingly, an object of the present invention is to provide a method for forming an oxide layer adhered well to the surface of a non-oxide ceramics shaped product without cracking and to provide a sintered non-oxide ceramics having higher performances and higher functions.
Another object of the present invention is to provide a cooling device that can eliminate the need to remove an ionization substance in a cooling medium.

A further object of the present invention is to provide an excellent plasma resistant member, which, even when exposed to plasma, does not generate particles on the surface of ceramics and, at the same time, can maintain high shape stability, by improving the densiness of an oxide layer in a non-oxide ceramics having an oxide layer on its surface.

### MEANS FOR SOLVING THE PROBLEM

The present invention has been made based on the following finding (1) to (3) obtained as a result of various studies conducted for realizing the formation of an ideal oxide film on the surface of an aluminum nitride shaped product by improving the above new oxidation process.
That is, the present invention has been made based on the following finding. (1) As a result of detailed analysis of "a non-oxide ceramics having an oxide layer on its surface" produced by a conventional oxidation process, in which an oxide film is formed by raising the temperature by heating in the air, or by the above-described new oxidation process, it was found that voids are formed in the oxide layer in its part around the interface of the oxide layer and the non-oxide ceramics. (2) In the above new oxidation process, when a method is adopted in which, before heat treatment, degassing treatment, in which the inside of a furnace containing an aluminum nitride shaped product is vacuum degassed, is carried out, and an ultrapure inert gas is introduced into the furnace followed by the start of heating, whereby the influence of gas released from the aluminum nitride shaped product and refractory lining of the furnace is eliminated as much as possible to accurately regulate the concentration of moisture and oxygen contained in the atmosphere at the time of heating of the sintered aluminum nitride substrate and, in addition, the pressure of the oxidizing gas in an early stage of the oxidation reaction is regulated in a specific range, it was found that the product has a macrostructural feature that the above-described characteristic cracks are not observed in the oxide film and further has a microstructural feature that the vicinity region of boundary of the aluminum nitride shaped product and the oxide film is free from voids. (3) The above phenomenon can be applied not only to the aluminum nitride molded product but also to aluminum nitride powder and to shaped products or powders of other non-oxide ceramics such as nitride ceramics and carbide ceramics.

The subject matters ([1] to [10]) of the present invention, which can attain the above objects of the present invention, will be summarized below.
[1] A method for producing a non-oxide ceramics having an oxide layer on its surface by oxidizing the surface of a non-oxide ceramics, characterized in that said method comprises the steps of:
   (1) providing a non-oxide ceramics;
   (2) introducing said non-oxide ceramics into a furnace, then discharging an oxidizing substance adsorbed or sorbed to said non-oxide ceramics or to a material constituting the furnace outside of the furnace, so as to reduce an oxidizing gas content in the atmosphere within the furnace to be not more than 0.5 mmol in terms of total number of moles of the oxidizing gas per m3 of the inside of the furnace;
   (3) heating said non-oxide ceramics to a temperature at or above a temperature, which is 300°C below the oxidation start temperature of said non-oxide ceramics, while maintaining the atmosphere in the furnace having an oxidizing gas content of not more than 0.5 mmol in terms of total number of moles of the oxidizing gas per m3 of the inside of the furnace; and
   (4) brining the non-oxide ceramics heated in said step (3) into contact with an oxidizing gas and then holding the non-oxide ceramics at a temperature above the oxidation start temperature of said non-oxide ceramics to form an oxide layer on the surface of said non-oxide ceramics, and that
   when bringing said non-oxide ceramics into contact with said oxidizing gas in said step (4), after the contact of said non-oxide ceramics and said oxidizing gas, until at least 2 min. elapses after the arrival of the temperature of said non-oxide ceramics at or above the oxidation start temperature thereof, the pressure or partial pressure of the oxidizing gas is maintained at not more than 50 kPa.
[2] A non-oxide ceramics having an oxide layer on its surface, characterized by comprising a non-oxide ceramics of a nitride or carbide of a metal or semimetal and a 0.1 to 100 µm-thick oxide layer provided on said surface of said non-oxide ceramics, said oxide being an oxide of an element identical to said metal or semimetal element, voids being substantially absent in said oxide layer in its region in a thickness of at least 20 nm from the boundary of said non-oxide ceramics and said oxide layer.
[3] The non-oxide ceramics having an oxide layer on its surface according to the above item [2], characterized in that, when a branched crack is divided into a crack unit located between adjacent branch points and crack units extending from the crack end to the nearest branch point, a branched crack having a crack unit having a w value of not less than 20 nm, an 1 value of not less than 500 nm and a w/l value of not less than 0.02, wherein 1 nm represents the length of each crack unit, and w nm represents the maximum width of each crack unit, is substantially absent on the surface of the oxide layer.
[4] The non-oxide ceramics having an oxide layer on its surface according to the above item [2] or [3], wherein said non-oxide ceramics is comprised of a sintered aluminum nitride, and the oxide layer consists essentially of polycrystalline α-alumina.
[5] A non-oxide ceramics having an oxide layer on its surface produced by the method according to the above item [1].
[6] A cooling device comprising: an exothermic element; a cooling jacket formed of the non-oxide ceramics having an oxide layer on its surface according to any one of the above items [2] to [5]; and cooling medium feeding means, wherein said exothermic element and the cooling jacket come into thermal contact with each other, a cooling medium is fed from said cooling medium feeding means into said cooling jacket, and an oxide layer is provided on the surface of said cooling jacket at least on its side which comes into contact with said cooling medium.
[7] A plasma resistant member comprising the non-oxide ceramics having an oxide layer on its surface according to any one of the above items [2] to [5].
[8] The plasma resistant member according to the above item [7], which is a member for constituting a chamber in a semiconductor or liquid crystal production apparatus comprising a plasma production mechanism.
[9] The plasma resistant member according to the above item [8], which is a wafer holder.
[10] The plasma resistant member according to the above item [9], which is a window material for high frequency wave introduction.

### EFFECT OF THE INVENTION

According to the method of the present invention, an oxide film having very high quality can be formed on the surface of non-oxide ceramics, for example, nitride ceramics such as aluminum nitride and silicon nitride, and carbide ceramics such as silicon carbide, and, at the same time, as compared with the oxidation by the conventional method (the method in which oxidation is carried out by raising the temperature in an oxidizing atmosphere), various effects attained by the formation of an oxide film, for example, improved water resistance and chemical resistance, improved plasma resistance, and improved mechanical strength can be further improved. Further, the "non-oxide ceramics having an oxide layer on its surface" produced by the method according to the present invention has such a structural feature that the oxide layer is substantially free from highly branched characteristic cracks observed in the oxide film formed by the conventional method and, at the same time, is substantially free from voids around the interface of the non-oxide ceramics base material and the oxide film. By virtue of this structural feature, the adhesion strength between the non-oxide ceramics base material and the oxide layer is very high, and, thus, the above-described various effects, that is, reliability and durability, can be enhanced.

In the cooling device according to the present invention, despite the fact that the cooling jacket is formed of a non-oxide ceramics having high thermal conductivity, since the cooling jacket in its part which comes into contact with cooling medium is covered with a high-quality oxide layer, there is no fear of causing a deterioration in non-oxide ceramics even when water or an aqueous solution is used as a cooling medium. Further, the oxide layer is in strong adhesion to the underlying non-oxide ceramics. The cooling jacket can be used stably for a long period of time without no particular necessity of strictly controlling the amount of ionization substance contained in the cooling medium.

Despite the fact that the plasma resistant member according to the present invention is formed of a non-oxide ceramics such as aluminum nitride, since the surface is free from cracks which have a large width and are highly branched, and has high densiness, the plasma resistant member is less likely to be deteriorated even upon exposure to plasma such as halogen-type corrosive gases. That is, the deterioration caused by the surface corrosion upon exposure to the plasma can be significantly reduced. When the member is for constituting a chamber used in the production process of semiconductors or liquid crystals, the generation of particles caused by the corrosion of the surface can be suppressed and, thus, the effect of preventing the contamination of wafers is large.

A change in shape of the member surface caused by the progress of the corrosion can also be suppressed. For example, when the member is a wafer holder for constituting the chamber, the reliability of the wafer holder can be maintained for a long period of time.
Further, the formation of a dense oxide layer on the surface can also improve the homogeneity of thermal conduction into the inside and, at the same time, is also effective in homogenizing heat dissipation and temperature distribution. Furthermore, since the oxide layer adheres strongly to the underlying non-oxide ceramics, the effect can be maintained for a long period of time even under severe service conditions such as a significant temperature change in a service environment.

### BRIEF DESCRIPTION OF THE DRAWINGS

[Fig. 1] Fig. 1 is a graph showing a reaction ratio and a DTA pattern when an aluminum nitride substrate is heated in an oxygen atmosphere.
[Fig. 2] Fig. 2 is a diagram illustrating specific cracks.
[Fig. 3] Fig. 3 is an SEM photograph of the surface of an oxide layer in an aluminum nitride substrate having an oxide layer on its surface produced in Example 1.
[Fig. 4] Fig. 4 is a sketch of the SEM photograph shown in Fig. 3.
[Fig. 5] Fig. 5 is a TEM photograph of the cross section of an oxide layer in an aluminum nitride substrate having an oxide layer on its surface produced in Example 1.
[Fig. 6] Fig. 6 is a sketch of the TEM photograph shown in Fig. 5.
[Fig. 7] Fig. 7 is an SEM photograph of the surface of an oxide layer in an aluminum nitride substrate having an oxide layer on its surface produced in Example 2.
[Fig. 8] Fig. 8 is a sketch of the SEM photograph shown in Fig. 7.
[Fig. 9] Fig. 9 is a TEM photograph of the cross section of an oxide layer in an aluminum nitride substrate having an oxide layer on its surface produced in Example 2.
[Fig. 10] Fig. 10 is a sketch of the TEM photograph shown in Fig. 9.
[Fig. 11] Fig. 11 is an SEM photograph of the surface of an oxide layer in an aluminum nitride substrate having an oxide layer on its surface produced in Comparative Example 1.
[Fig. 12] Fig. 12 is a sketch of the SEM photograph shown in Fig. 11.
[Fig. 13] Fig. 13 is an SEM photograph of the surface of an oxide layer in an aluminum nitride substrate having an oxide layer on its surface produced in Comparative Example 2.
[Fig. 14] Fig. 14 is a sketch of the SEM photograph shown in Fig. 13.
[Fig. 15] Fig. 15 is a TEM photograph of the cross section of an oxide layer in an aluminum nitride substrate having an oxide layer on its surface produced in Comparative Example 1.
[Fig. 16] Fig. 16 is a sketch of the TEM photograph shown in Fig. 15.
[Fig. 17] Fig. 17 is a TEM photograph of the surface of an oxide layer in an aluminum nitride substrate having an oxide layer on its surface produced in Comparative Example 2.
[Fig. 18] Fig. 18 is a sketch of the TEM photograph shown in Fig. 17.
[Fig. 19] Fig. 19 is a cooling system diagram of a typical cooling device according to the present invention.
[Fig. 20] Fig. 20 is an SEM photograph of the surface of an oxide layer in an aluminum nitride substrate having an oxide layer on its surface produced in Example 8.
[Fig. 21] Fig. 21 is a sketch of the SEM photograph shown in Fig. 20.
[Fig. 22] Fig. 22 is a TEM photograph of the cross section of an oxide layer in an aluminum nitride substrate having an oxide layer on its surface produced in Example 8.
[Fig. 23] Fig. 23 is a sketch of the TEM photograph shown in Fig. 22.
[Fig. 24] Fig. 24 is an SEM photograph showing a surface state of a surface oxidized aluminum nitride susceptor produced in Example 8 before a plasma treatment in carrying out a corrosion resistance test II.
[Fig. 25] Fig. 25 is an SEM photograph showing a surface state of the surface oxidized aluminum nitride susceptor shown in Fig. 24 after the plasma treatment.
[Fig. 26] Fig. 26 is an SEM photograph showing a surface state of an aluminum nitride susceptor not having an oxide layer on its surface before a plasma treatment in carrying out a corrosion resistance test II.
[Fig. 27] Fig. 27 is an SEM photograph showing a surface state of the surface oxidized aluminum nitride susceptor shown in Fig. 24 after the plasma treatment.
[Fig. 28] Fig. 28 is an SEM photograph of the surface of an oxide layer in an aluminum nitride substrate having an oxide layer on its surface produced in Example 9.
[Fig. 29] Fig. 29 is a sketch of the SEM photograph shown in Fig. 28.
[Fig. 30] Fig. 30 is a TEM photograph of the cross section of an oxide layer in an aluminum nitride substrate having an oxide layer on its surface produced in Example 9.
[Fig. 31] Fig. 31 is a sketch of the TEM photograph shown in Fig. 30.
[Fig. 32] Fig. 32 is an SEM photograph of the surface of an oxide layer in an aluminum nitride substrate having an oxide layer on its surface produced in Comparative Example 8.
[Fig. 33] Fig. 33 is a sketch of the SEM photograph shown in Fig. 32.
[Fig. 34] Fig. 34 is an SEM photograph of the surface of an oxide layer in an aluminum nitride substrate having an oxide layer on its surface produced in Comparative Example 9.
[Fig. 35] Fig. 35 is a sketch of the SEM photograph shown in Fig. 34.
[Fig. 36] Fig. 36 is a TEM photograph of the cross section of an oxide layer in an aluminum nitride substrate having an oxide layer on its surface produced in Comparative Example 8.
[Fig. 37] Fig. 37 is a sketch of the TEM photograph shown in Fig. 36.
[Fig. 38] Fig. 38 is a TEM photograph of the surface of an oxide layer in an aluminum nitride substrate having an oxide layer on its surface produced in Comparative Example 9.
[Fig. 39] Fig. 39 is a sketch of the TEM photograph shown in Fig. 38.

### DESCRIPTION OF REFERENCE CHARACTERS

- 1 ···: branched cracks,
- 2a to 2e···: crack units,
- 1a to 1e···: each crack unit length,
- wa to we ···: maximum width of each crack unit,
- (I) ···: cooling unit for exothermic element,
- (II)···: cooling medium feeding unit,
- 100 ···: cooling device,
- A ···: substrate,
- B ···: exothermic element,
- C ···: cooling medium,
- D ···: cooling jacket,
- E ···: piping,
- F ···: tank,
- G ···: pump, and
- H···: heat exchanger.

### BEST MODE FOR CARRYING OUT THE INVENTION

According to the production process of the present invention, a non-oxide ceramics (hereinafter referred to also simply as "object ceramics") is first provided.
In the present invention, the non-oxide ceramics (object ceramics) on which an oxide film is to be formed, is not particularly limited so far as the non-oxide ceramics is a nitride or carbide of a metal or semi-metal, of which the melting point or decomposition temperature, is equal to or above the oxidation start temperature, and conventional nitrides or carbides may be used. Specific examples of non-oxide ceramics suitable for use in the present invention include nitride ceramics such as aluminum nitride, silicon nitride, and boron nitride, and carbide ceramics such as silicon carbide, titanium carbide, and zirconium carbide. Among them, aluminum nitride and silicon nitride are suitable because of their high usefulness in industry. Non-oxide ceramics used in the present invention may be crystalline non-oxide ceramics such as monocrystalline or polycrystalline non-oxide ceramics, amorphous non-oxide ceramics or non-oxide ceramics comprising a crystal phase and an amorphous phase as a mixture, and, further, sintered body produced by adding a sintering aid and optionally other additives to non-oxide ceramics powder and sintering the mixture. For the non-oxide ceramics, the shape, size and the like are not also particularly limited, and, for example, non-oxide ceramics which have been fabricated into any desired shape such as plates or special shape ceramics, and thin-film non-oxide ceramics may be used. In the present invention, the use of sintered body produced by previously shaping aluminum nitride or silicon nitride into any predetermined shape and sintering the shaped product is suitable as the object ceramics from the viewpoints of high usefulness, inexpensive price, easy availability, and high effect of the present invention.

Further, when the non-oxide ceramics having an oxide layer produced by the present invention is used as a cooling member or a plasma resistant member, the use of a sintered body which has been previously fabricated into a predetermined shape is preferred. Alternatively, however, a method may also be adopted in which an oxide film is formed on a block of an object ceramics and the assembly is then fabricated into a desired shape.
For example, when the non-oxide ceramics is a sintered aluminum nitride, the sintered aluminum nitride used may be suitably produced by adding at least one additive selected from the group consisting of yttria, calcia, calcium nitrate, and barium carbonate to aluminum nitride powder, shaping the mixture into a predetermined shape by a conventional method, and then sintering the shaped product, or by further fabricating the sintered body. On the other hand, when the non-oxide ceramics is a sintered silicon nitride, the sintered silicon nitride used may be suitably produced by adding at least one additive selected from the group consisting of magnesium oxide, chromic oxide, alumina, yttria, zirconia, aluminum nitride, silicon carbide, boron, and boron nitride to the silicon nitride powder, shaping the mixture into a predetermined shape by a conventional method, and sintering the shaped product, or by further fabricating the sintered body.

In the present invention, the object ceramics may also be subjected to pretreatment such as roughening or polishing of the surface. For example, etching with an aqueous alkaline solution, or sandblasting may be mentioned as the roughening treatment. Polishing with abrasive grains and polishing by electrolytic in-process dressing grinding may be mentioned as the polishing treatment. A method may also be adopted in which a material, which serves as a sintering aid for an oxide (for example, aluminum oxide or silicon oxide) for constituting the oxide layer to be formed, or its precursor is previously adhered onto the surface of the object ceramics. Such materials include SiO2, MgO, CaO, B2O3, and Li2O.

In the production process of the present invention, after the above object ceramics is introduced into a furnace, the atmosphere within the furnace is regulated so as to have an oxidizing gas content of not more than 0.5 mmol in terms of total number of moles of the oxidizing gas per m3 of the inside of the furnace (degassing treatment). The term "oxidizing gas" as used herein refers to gas capable of oxidizing non-oxide ceramics, for example, oxygen gas, water vapor, carbon dioxide gas, or carbon monoxide gas. Not only gas contained in the atmosphere but also gas adsorbed or sorbed onto refractory lining in the furnace is included in the oxidizing gas. When the atmosphere at the time of heating is an atmosphere containing a large amount of oxidizing gas such as air, during the oxidation reaction, the occurrence of the above-described characteristic cracks, more specifically the occurrence of "a branched crack having a crack unit simultaneously having a w value of not less than 20 nm, an 1 value of not less than 500 nm and a w/l value of not less than 0.02, wherein 1 nm represents the length of each crack unit, and w nm represents the maximum width of each crack unit, when a branched crack is divided into a crack unit located between adj acent branch points and a crack unit extending from the crack end to the nearest branch point" (hereinafter referred to also as "specific cracks") is unavoidable, probably because the oxidizing gas or oxidizing gas-derived oxygen is disadvantageously dissolved as a solid solution in the object ceramics during heating. The occurrence of the above specific cracks can be suppressed by adopting an inert gas atmosphere, such as nitrogen gas, as the atmosphere at the time of heating. When the total concentration of the oxidizing gas contained in the inert gas exceeds 0.5 mmol/m3 (0.00112% by volume), voids are disadvantageously formed around the interface of the oxide layer and the non-oxide ceramics. As a result, the adhesion strength between the non-oxide ceramics and the oxide layer cannot be enhanced. From the viewpoint of the effect, the total concentration of the oxidizing gas contained in the atmosphere, particularly the total concentration of oxygen and steam, is suitably not more than 0.1 mmol/m3, particularly not more than 0.01 mmol/m3.

The atmosphere at the time of heating refers to an actual atmosphere within the furnace in which the influence of gas released from the furnace wall and the non-oxide ceramics as the object ceramics during temperature raising/heating has been added. For example, even when temperature raising/heating is carried out while allowing a high-purity inert gas to flow into the furnace, oxygen or water vapor is released from the furnace wall and the object ceramics in the case where degassing treatment is not previously carried out. As a result, the purity of the inert gas is lowered, and, thus, the composition of the atmosphere gas during the heating is not identical to the composition of the introduced gas. In this case, the composition of the atmosphere gas during heating can be confirmed by the analysis of gas discharged from the furnace. In the present invention, there is no need to accurately control the atmosphere during a period in which, after the start of heating, the temperature of the object ceramic is not very high. However, at least the atmosphere in a heating process wherein the temperature of the object ceramics is brought to 100°C or above, more preferably 200°C or above, should be controlled so that the total concentration of the oxidizing gas, particularly the total concentration of oxygen molecules and water molecules, falls within the above-defined range.

In the production process according to the present invention, subsequent to the degassing treatment, the object ceramic is heated to a temperature at or above a temperature, which is 300°C below the oxidation start temperature of said object ceramics, while maintaining the atmosphere in the furnace so as to have an oxidizing gas content of not more than 0.5 mmol in terms of total number of moles of the oxidizing gas per m³ of the inside of the furnace (hereinafter referred to also as "heating step"). Heating while maintaining the atmosphere can be carried out by any method without particular limitation. A suitable method is that, after the degassing treatment, the atmosphere in the furnace is sufficiently replaced by a high-purity inert gas having a purity of not less than 99.999%, more preferably not less than 99.9999%, most preferably not less than 99.99995%, followed by heating under the flow of the inert gas, or that the pressure within the furnace during heating is always maintained at not more than 100 Pa, preferably not more than 40 Pa, most preferably not more than 20 Pa. The degassing treatment may be carried out by any method without particular limitation so far as gas adsorbed onto the surface or gas absorbed within the ceramics can be desorbed. A suitable method is to conduct degassing at a temperature in the range of room temperature to 100°C under reduced pressure until the desorption of the gas is completed. The degree of reduced pressure (pressure within the furnace) in the degassing treatment is not particularly limited, but is preferably not more than 100 Pa, particularly not more than 20 Pa, most preferably not more than 1 Pa. The degassing and the inert gas replacement are preferably carried out a plurality of times.

In the production process according to the present invention, it is important that, until the start of the oxidation of the object ceramics, the oxidizing gas or the oxidizing gas-derived oxygen is not substantially dispersed in the object ceramics. To this end, until the temperature reaches the oxidation reaction start temperature, heating is preferably carried out in the above atmosphere. However, when the object ceramics is heated to a temperature at or above a temperature which is 300°C below the oxidation start temperature of the object ceramic, even with the introduction of an oxygen gas into the system (furnace), the regulation of the temperature rise rate (even when the temperature rise rate is, for example, in the range of 10 to 80°C/min, preferably 30 to 50°C/min, which is practically controllable) can realize heating of the object ceramic to the oxidation reaction start temperature without causing undesirable oxygen dispersion and without significant damage to the object ceramics. When the heating temperature is below a temperature which is 300°C below the oxidation start temperature of the object ceramics, in order to raise the temperature of the object ceramics to the oxidation start temperature without causing diffusion of oxygen and the like which adverse affect oxide layer formation, the temperature rise rate should be increased. The heating at the high temperature rise rate disadvantageously involves deformation or the occurrence of cracks depending upon the shape of the object ceramics. Preferably, the object ceramics is heated to a temperature at or above a temperature which is 100°C below the oxidation start temperature of the object ceramics, particularly to a temperature at or above the oxidation start temperature of the object ceramic in the above atmosphere, although this also varies depending upon the performance of the furnace used and the shape of the object ceramics. Here the oxidation start temperature refers to a temperature at which, when the object ceramics is heated under an oxidizing gas atmosphere, an oxidation reaction takes place rapidly. In the present invention, the oxidation start temperature refers to a temperature at which, when the object ceramics is heated at a heating up rate of 1 to 100°C/min, preferably 75°C/min, under the reaction pressure in an oxygen atmosphere, the oxidation reaction ratio of the object ceramics changes critically. The oxidation start temperature can easily be specified as the temperature at which, in the results of thermogravimetric analysis in heating the object ceramics under the above conditions, a rapid weight change starts, or as the temperature at which, in the results of differential thermal analysis, rapid heat generation starts. For example, the oxidation start temperature of aluminum nitride under the atmospheric pressure is 1100°C, as shown in Fig. 1.

In the production process of the present invention, after the object ceramics heated to a temperature at or above a temperature, which is 300°C below the oxidation start temperature of said object ceramic, in an atmosphere having an oxidizing gas content of not more than 0.5 mmol in terms of total number of moles of the oxidizing gas per m3 of the inside of the furnace is brought into contact with an oxygen gas, the object ceramics is held at a temperature above the oxidation start temperature of the object ceramics to oxidize the surface of the object ceramics base material and thus to form an oxide layer (hereinafter referred to also as "oxidation step").

In this case, in order to avoid the occurrence of defects such as cells or voids in the boundary of the oxide layer and the non-oxide ceramics, it is important that, in addition to accurately control the atmosphere during temperature raising, in bringing the object ceramics into contact with the oxidizing gas, the atmosphere be accurately controlled in a predetermined period after the start of the contact (hereinafter referred to also as "initial contact period"). That is, in the production process of the present invention, the pressure or partial pressure of the oxidizing gas should be maintained at not more than 50 kPa until at least 2 min. elapses after the arrival of the temperature of said object ceramics at or above the oxidation start temperature of said non-oxide ceramics after the start of the contact between said object ceramics and said oxidizing gas. More specifically, the pressure or partial pressure of the oxidizing gas should be maintained at not more than 50 kPa in a period until 2 min. or longer elapses after the start of contact when the contact is started at a temperature at or above the oxidation start temperature, or a period of the sum of a period until the temperature reaches the oxidation start temperature after the start of the contact, and a period until 2 min. or longer elapses after the temperature reaches the oxidation start temperature when the contact is started at a temperature below the oxidation start temperature. After the expiration of the initial contact period, any defect does not occur even when the pressure or partial pressure of the oxidizing gas is increased to a value exceeding the above upper limit value. This is probably because the structure of the boundary is determined in an early stage of the oxidation reaction and, after the formation of a thin oxide film in a good state, the good interfacial state is also maintained in the subsequent stage of growing the oxide film.

When the pressure or partial pressure of the oxidizing gas in the initial contact period exceeds the upper limit of the above-defined range, defects occur in the vicinity region of boundary of the oxide layer and the non-oxide ceramics and, consequently, the adhesion strength between the oxide layer and the non-oxide ceramics is lowered. In this case, the oxide layer is sometimes peeled off, for example, in a heat cycle test. From the viewpoint of attaining the effect of preventing the occurrence of defects in the boundary, preferably, the pressure or partial pressure of the oxidizing gas is brought to not more than 40 kPa, particularly preferably not more than 30 kPa, in a period until at least 2 min. elapses after the arrival of the temperature of said non-oxide ceramics at or above the oxidation start temperature of said non-oxide ceramics after the start of the contact between said object ceramics and said oxidizing gas, and is brought to not more than 55 kPa, particularly preferably not more than 50 kPa, in a period until at least 3 min. elapses after the temperature reaches the oxidation start temperature.

In the oxidation step, when the object ceramics heated to a predetermined temperature is brought into contact with the oxidizing gas, the following method may be adopted. The temperature of the object ceramics is monitored. After it is confirmed that the temperature of the object ceramics has reached a predetermined temperature, an oxidizing gas having a predetermined pressure, or a mixed gas comprising an oxidizing gas diluted with an inert gas and having a predetermined oxidizing gas partial pressure is introduced into the furnace. The object ceramics is held at a temperature at or above the oxidation start temperature in the presence of the gas for a predetermined period of time or longer, and, if necessary, the pressure or partial pressure of the oxidizing gas is increased. In this case, the pressure or partial pressure of the oxidizing gas in the initial contact period may be either constant or varied. From the viewpoint of the effect of preventing the occurrence of defects in the boundary, preferably, the pressure or partial pressure of the oxidizing gas is increased from 0 Pa either stepwise or continuously with the elapse of time in such a range that does not exceed the upper limit value of the above-defined pressure or partial pressure range. When the untreated ceramic has a complicated shape and the oxidation of the surface of the complicated shape is contemplated, preferably, the pressure of the oxidizing gas or an oxidizing gas-containing gas (hereinafter referred to also as "gas for oxidation") is fluctuated from the viewpoint of improving the contact of the untreated ceramics with the gas for oxidation.

In the heating step under the flow of an inert gas, when the introduction of the inert gas is stopped followed by the introduction of the oxidizing gas, the atmosphere within the furnace is not immediately replaced by the oxidizing gas. Therefore, the partial pressure of the oxidizing gas in the initial contact period can be regulated by regulating the flow rate of the oxidizing gas while taking into consideration the space of the furnace into which the gas is introduced, and the gas flow state. In this case, however, care should be taken to the introduction of the oxidizing gas, because the diffusion of the gas is influenced by the gas introduction site and the structure within the furnace, often resulting in locally increased partial pressure of the oxidizing gas.

A good oxide layer can be formed when the temperature at which the contact between the object ceramics and the oxidizing gas is started, is a temperature at or above a temperature which is 300°C below the oxidation start temperature of said obj ect ceramics. In order to more reliably form a good oxide layer, preferably, the temperature at which the contact between the object ceramics and the oxidizing gas is started, is a temperature at or above a temperature which is 100°C below the oxidation start temperature of said object ceramics, particularly preferably a temperature at or above the oxidation start temperature of the object ceramics.

The oxidizing gas or oxidizing gas-containing gas (gas for oxidation) used for the oxidation of the object ceramics in the oxidation step may be the above-described oxidizing gas without particular limitation. From the viewpoint of causing no significant defect in the oxide layer, the use of a gas having a dew point of -50°C or below is preferred, and the use of a gas having a dew point of -70°C or below is most preferred. For example, ultrahigh pure oxygen gas, ultrahigh pure carbon monoxide gas, ultrahigh pure carbon dioxide gas, a mixed gas composed of two or more of these gases, a mixed gas prepared by diluting these ultrahigh pure gases with an ultrahigh pure inert gas, and dehydrated air are preferred.

The concentration of the oxidizing gas in the gas for oxidation affects the oxide layer formation rate. In general, the higher the oxygen concentration, the higher the oxide layer formation rate. Therefore, from the viewpoint of efficiency, after the expiration of the initial contact period, the use of a gas having an oxygen concentration of not less than 50% by volume as the gas for oxidation is preferred, and the use of a gas having an oxygen concentration of not less than 99% by volume is particularly preferred.
In the oxidation step, the object ceramics should be contacted with the gas for oxidation at a temperature at or above the oxidation start temperature. When the oxidation temperature is excessively high, the energy cost is high and, at the same time, the regulation of the thickness of the oxide layer is difficult. Therefore, the oxidation temperature is preferably at or below a temperature which is 500°C above the oxidation start temperature, particularly preferably at or below a temperature which is 300°C above the oxidation start temperature. The oxidation time may be properly determined by taking into consideration the concentration of oxygen in the gas for oxidation, the oxidation temperature, and the thickness of the oxide layer to be formed. For example, in order to provide aluminum nitride having a 1000 to 3000 nm-thick α-alumina layer, the object ceramic may be generally held at a temperature above the oxidation start temperature for 0.5 to 50 hr. The oxide layer formed in the oxidation step is made of an oxide of a metal or semi-metal as a constituent element of the non-oxide ceramics as the object ceramics. Nitrogen or carbon may be dissolved as a solid solution in the oxide layer depending upon the type of the object ceramics.

After the completion of the oxidation treatment, the oxidized non-oxide ceramics may be cooled and taken out of the furnace. At the time of cooling, preferably, the oxidized non-oxide ceramics is gradually cooled so as to avoid damage to the non-oxide ceramics and the oxide layer.
The non-oxide ceramics having an oxide layer on its surface produced by the production process according to the present invention is characterized in that voids or cells are not substantially present in the oxide layer around the boundary of the non-oxide ceramics and the oxide layer, and the adhesion strength between the non-oxide ceramics layer and the oxide layer is very high. In the non-oxide ceramics having an oxide layer on its surface produced by the production process according to the present invention, the region substantially free from voids or cells around the boundary of the oxide layer and the non-oxide ceramics (hereinafter referred to also as "void-free region") is a layer region spread in a certain thickness from the boundary over the whole area of the oxide layer. The thickness of the void-free region is 20 to 100 nm independently of the thickness of the whole oxide layer. Here, substantial freedom from voids or cells means that the void ratio in the void-free region (the proportion of the volume of voids to the whole void-free region) is not more than 5%, preferably not more than 3%, particularly preferably not more than 1%. A number of voids having a diameter of about 50 to 100 nm are observed in the oxide layer region other than the void-free region, particularly the region except for the area around the surface layer, whereas, in the void-free region, such voids are hardly observed and, even when voids are present, most of the voids have a diameter of not more than 5 nm, preferably not more than 1 nm. Regarding the surface layer part in the oxide layer, there is a tendency that, when the thickness of the oxide layer is increased, the voids are reduced and, consequently, the diameter is increased.

When the non-oxide ceramics is a sintered non-oxide ceramics, it is well known that, in the course of producing the sintered ceramics, crystals of a sintering aid are precipitated on the surface of the sintered ceramic. When this sintered ceramics is oxidized in the production process of the present invention, an oxidation reaction proceeds also in the grain boundary between the crystal of the sintering aid and the sintered non-oxide ceramics and, consequently, the non-oxide ceramics in its part just under the precipitated sintering aid crystal is also oxidized. In this case, the boundary of the oxide layer in its part and the sintered non-oxide ceramics is free from defects such as cells or voids. This fact suggests that, even when a small amount of foreign matter is present on the surface of the non-oxide ceramics, the foreign matter is embraced in the oxide layer and, consequently, the product is less likely to be adversely influenced by the foreign matter. The present invention is also valuable in this point.

The presence of the void-free region can be confirmed by the observation of the cross section of the sample by a transmission electron microscope (TEM). In this case, voids are observed in the TEM photograph as a white- or lightness-color distorted elliptical (in some case, seen like a polygonal shape) pattern. When the thickness of the observed sample is uneven, the determination of the voids is difficult. Therefore, the thickness of the sample for observation by TEM should be even and in the range of 50 to 100 nm. The above sample can be prepared as follows. Specifically, in a focused ion beam (FIB) system widely used in the preparation of samples for TEM observation, the sample is polished by accelerated gallium ion. In this case, the periphery is polished so that, as viewed from the sample surface, a region having a breadth of 10 to 20 µm and a length of 50 to 100 nm is left. The polishing region can be confirmed by a scanning ion microscope (SIM) which, upon the application of gallium ion, detects secondary electrons generated from the sample to obtain an image. In general, SIM is attached to an FIB apparatus, and the polishing region can be accurately confirmed by this SIM observation and, thus, a sample for TEM observation having an even thickness in the range of 50 to 100 nm can be prepared.

The non-oxide ceramics having an oxide layer on its surface produced by the production process according to the present invention is also characterized in that, the specific crack defined by "when branched cracks are divided into crack units located between adjacent branch points and crack units extending from the end to the nearest branch point, a branched crack having a crack unit meeting a w value of not less than 20 nm, an 1 value of not less than 500 nm and a w/l value of not less than 0.02, wherein 1 nm represents the length of each crack unit, and w nm represents the maximum width of each crack unit" is substantially absent in the oxide layer formed on the surface of the non-oxide ceramic.

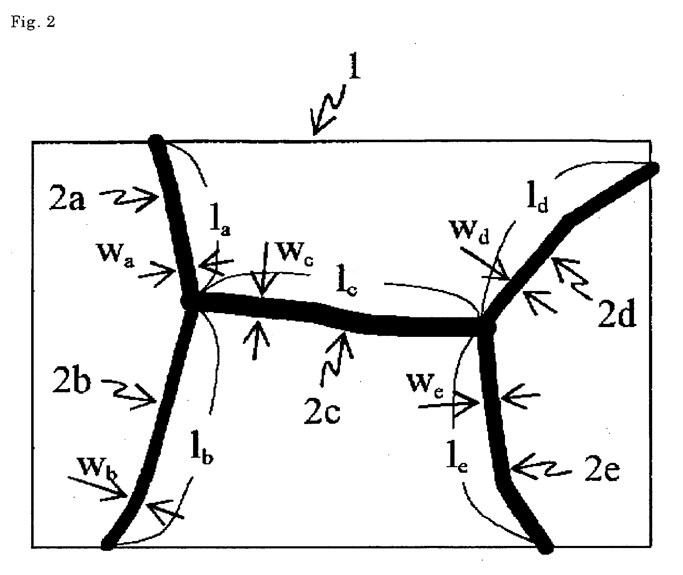

The above specific cracks will be further described in more detail with reference to the accompanying drawings. When the branched crack 1 has a shape as shown in Fig. 2, 2a to 2e represent respective crack units. In the determination of 1, w and w/l for each crack unit, when even one crack unit simultaneously has a w value of not less than 20 nm, an l value of not less than 500 nm and a w/l value of not less than 0.02 preferably not less than 0.01, the branched crack 1 is regarded as a specific crack. When none of the crack units meet a w/l value of not less than 0.02, preferably not less than 0.01, the branched crack 1 is not a specific crack. The absence of the specific crack can be confirmed by the observation of the surface of the oxide layer by a scanning electron microscope. Substantial absence of the specific crack means that, for one sample, the number of specific cracks found in the observation of arbitrarily selected 10 visual fields (visual fields having a radius of 30000 nm), preferably 50 visual fields, is not more than 0.2, preferably not more than 0.1, most preferably not more than 0.05, on average per one visual field. Concaves and convexes are often formed on the surface of the oxide film as a result of a reflection of the shape of the underlying non-oxide ceramics, or depending upon the way of growth of the oxide film. The concaves observed in this case are not cracks, and the crack referred to in the present invention is a crack by which at least the surface layer part in the oxide layer is discontinuously broken.

The non-oxide ceramics having an oxide layer on its surface produced by the process of the present invention has the above-described good oxide layer, the effect to be expected by the formation of the oxide layer can be satisfactorily attained, and, thus, the non-oxide ceramics having an oxide layer on its surface is suitable for various applications such as plasma resistant members, and cooling members in cooling devices. For example, a structural material such as an automobile engine member, formed of a nitride ceramics (particularly silicon nitride) having a 0.1 to 100 µm-thick, preferably 1 to 50 µm-thick oxide layer, has higher strength and higher durability than a structural material having an oxide film formed by the conventional oxidation method. Further, a sintered ceramic produced by forming a green body using a powder of a nitride ceramics having an oxide layer on its surface produced by the production process according to the present invention and then sintering the green body has higher strength and higher water resistance than a sintered ceramic using a powder of a nitride ceramic having an oxide film formed by the conventional oxidation method.

The cooling device according to the present invention has the same construction as the conventional cooling device (cooling device having standard construction), except that a cooling jacket is formed of a member comprising the above non-oxide ceramics having an oxide layer. Specifically the cooling device according to the present invention comprises: an exothermic element; a cooling jacket formed of the non-oxide ceramics member having an oxide layer on its surface; and cooling medium feeding means, wherein said exothermic element and the cooling jacket come into thermal contact with each other, a cooling medium is fed from said cooling medium feeding means into said cooling jacket, and an oxide layer is provided on the surface of said cooling jacket at least on its side which comes into contact with said cooling medium. The cooling device according to the present invention will be described with reference to the accompanying drawings.

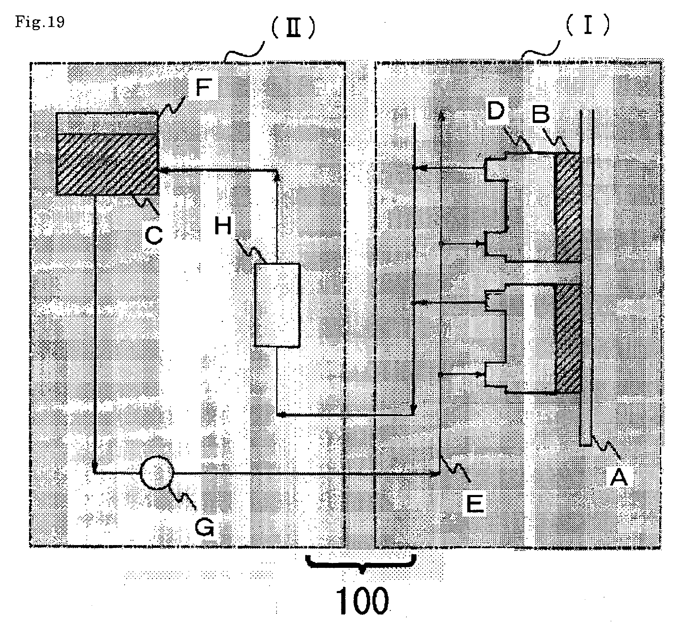

Fig. 19 is a cooling system diagram of a typical cooling device 100 according to the present invention. The cooling device shown in Fig. 19 comprises two blocks, i.e., an exothermic element cooling unit (I) for cooling an exothermic element B such as a semiconductor element and an integrated circuit and a cooling medium feeding unit (II). In the exothermic element cooling unit (I), a plurality of exothermic elements B are mounted on the substrate A. A cooling jacket D for cooling the exothermic element B upon the feed of a cooling medium C, for example, water, is provided on the exothermic elements B. The jacket D is in thermal contact with the exothermic elements B, and a flow passage (cavity), through which the cooling medium C is passed, is provided within the jacket D. Liquids used as cooling media in conventional cooling devices may be used as the cooling medium without particular limitation. From the viewpoint of easy control, water or a mixed liquid composed of water and a water soluble organic solvent is preferred. Preferred water soluble organic solvents include ethylene glycol and ethanol.

The cooling medium feeding unit (II) functions as means for feeding the cooling medium C for cooling the exothermic element into the cooling jacket D and comprises a tank F, cooling medium transfer means such as a pump G, and a heat exchanger H. The exothermic element cooling unit (I) is connected to the cooling medium feeding unit (II) through piping E. The cooling medium C is discharged from the tank F in the cooling medium feeding unit (II), is then pressurized in the pump G and is fed into the exothermic element cooling unit (I). Further, the heat transfer medium C cools the exothermic element B in the cooling jacket D and is then returned to the cooling medium feeding unit (II) where the cooling medium is again cooled by a heat exchanger H. In Fig. 19, the heat exchanger H is provided in a line, returned from the jacket D to the tank F, in its position between the jacket D and the tank F. However, the position at which the heat exchanger H is provided, is not particularly limited. The heat exchanger H and the tank F may have been integrated with each other (not shown). Further, if the heat exchanger has a satisfactory cooling capability, then there is no particular need to provide the tank F.

In the cooling device according to the present invention, there is no fear of causing the cooling jacket to be deteriorated by the contact thereof with the cooling medium. Therefore, the provision of any device for removing ions contained in the cooling medium in the exothermic element cooling unit (II) is not particularly required. However, when the cooling medium is used for a long period of time, in some times, the cooling efficiency is lowered due to a deterioration in the cooling medium. Accordingly, the provision of means for maintaining the state of the cooling medium in a given state range is preferred. Means for periodically or continuously replacing a part or the whole of the cooling medium with a fresh cooling medium, or means for periodically or continuously purifying a part or the whole of the cooling medium may be mentioned as such means.

The most characteristic feature of the cooling device according to the present invention is that the cooling jacket is constructed by the member formed of a non-oxide ceramics having an oxide layer according to the present invention. The oxide layer in the non-oxide ceramics having an oxide layer according to the present invention has high quality free form any defect, can shield the underlying non-oxide ceramics against the cooling medium such as water, and can effectively protect the non-oxide ceramics. Further, no defect exists in the vicinity of boundary of the non-oxide ceramics and the oxide layer. Therefore, the heat cycle resistance is high, and, even when the cooling device is repeatedly operated and stopped, the performance is not deteriorated. Although the thickness of the oxide layer is not particularly limited, the thickness is preferably 0.1 to 100 µm, more preferably 0.5 to 50 µm, still more preferably 0.8 to 10 µm, from the viewpoints of base material protection effect and thermal conductivity.

The plasma resistant member according to the present invention will be described. The plasma resistant member according to the present invention is formed of the non-oxide ceramics having an oxide layer. The plasma resistant member is not limited so far as the member can be used in such an environment that at least a part of the surface of the member is exposed to plasma. In this case, the oxide layer formed face may be used as the surface exposed to plasma. Conventional plasma gas generation gases such as oxygen, argon, nitrogen, and helium may be adopted without particular limitation as the plasma generation gas. Specifically, the plasma resistant member may be used as a member for constructing a chamber for an apparatus for generating plasma by introducing 10 MHz to 300 GHz, particularly 1 to 100 GHz, for example, microwaves or milliwaves, into a chamber, for example, in plasma polymerization apparatus, plasma thermal spraying apparatus, or plasma etching apparatus.

Preferably, the member is a member for constituting a chamber in production apparatuses provided with a plasma generation mechanism, which are used in the step of forming a thin film on a semiconductor wafer or a wafer such as a glass substrate for liquid crystals, or the step of etching in the production process of a semiconductor or a liquid crystal. In these apparatuses, since plasma is generally generated in the presence of a halogen-type corrosive gas, the problem of a deterioration in the member for constituting a chamber caused by exposure to the plasma is significantly accelerated. As a result, the occurrence of particles on the member surface caused by corrosion and a change in shape with the progress of the corrosion is significant, and, thus, the effect of the present invention is more significantly attained.

Among the members for constituting a chamber in semiconductor or liquid crystal production apparatuses provided with a plasma generation mechanism, the plasma resistant member according to the present invention is particularly preferably applied to wafer holders such as susceptors or electrostatic chucks for holding wafers. The susceptor is formed of a disk-shaped substrate and is constructed so that a wafer is mounted on the substrate in its holding face and the peripheral part of the wafer is pressed by a ring-shaped clamp ring to hold the wafer. The electrostatic chuck is constructed so that an electrode is buried within the disk-shaped substrate, a wafer is mounted on the substrate in its holding face, and voltage is applied across the wafer and the electrode to electrostatically adsorb the wafer on the holding face for holding the wafer.

Further, the member for constituting a chamber is suitably a window material for high frequency wave introduction for generating plasma, because the window material is particularly influenced by the plasma. The member for constituting a chamber is also suitable, for example, as high frequency coupling antennas, monitor windows within chambers, and inner wall materials within chambers.
Also in the plasma resistant member according to the present invention, since no defect exists in the vicinity of boundary of the non-oxide ceramics and the oxide layer, the excellent effect can be continued for a long period of time.

The present invention will be described in more detail with reference to the following Examples. However, it should be noted that the present invention is not limited to these Examples.
Example 1
A sintered aluminum nitride substrate in a plate form having a size of 50.8 mm in length, 50.8 mm in width, and 0.635 mm in thickness and a surface roughness Ra of not more than 0.05 µm (SH 15, manufactured by TOKUYAMA Corp.) was introduced into a high-temperature atmosphere furnace comprising a mulite ceramic having an inner diameter of 75 mm and a length of 1100 mm as a furnace tube (SUPER BURN rebuilt type, manufactured by MOTOYAMA Co., Ltd.). The inside of the furnace was evacuated by a rotary vacuum pump to not more than 50 Pa. Thereafter, the atmosphere in the evacuated furnace was replaced by nitrogen gas (purity 99.99995%, dew point -80°C) by pressure increase, and the furnace was heated to 1200°C (heating up rate: 3.3°C/min.) under nitrogen flow at a flow rate of 2 (l/min.). After the temperature around the substrate was confirmed to reach 1200°C, the nitrogen gas flow was stopped. Next, oxygen gas (purity 99.999%, dew point -80°C) was flowed at a flow rate of 1 (l/min.), and this condition was held for one hr to oxidize the surface of the aluminum nitride substrate. After the completion of oxidation, the substrate was cooled to room temperature (cooling down rate: 3.3°C/min.) to provide a surface oxidized aluminum nitride substrate according to the present invention.

At the same time as the start of the temperature raising, gas discharged from the furnace was introduced into a gas chromatograph (personal gas chromatograph GC-8A, manufactured by Shimadzu Seisakusho Ltd., detector: TCD, column: SUS 3 φ x 2 m, filler: molecular sieve 13 X-S 60/80, manufactured by GL Sciences Inc.) and was analyzed for components over time. As a result, during temperature raising, any component other than nitrogen was not detected in any temperature region. When 10 min. elapsed from the start of flow of oxygen into the furnace, the waste gas was analyzed. As a result, in addition to oxygen as the flow gas, nitrogen considered to have been produced in the reaction process was detected. The height of the nitrogen peak became the highest value after the start of oxygen flow and reduced with the elapse of the temperature holding time. The partial pressure of oxygen gas in a portion around the sample 2 min and 3 min after the start of introduction of oxygen was determined from a nitrogen peak reduction pattern and a separately prepared calibration curve. As a result, the partial pressure 2 min. after the start of introduction of oxygen and the partial pressure 3 min after the start of introduction of oxygen were 28 kPa and 47 kPa, respectively.

The surface oxidized aluminum nitride substrate (sample) was analyzed by X-ray diffractometry (XRD), a scanning electron microscope (SEM) and a transmission electron microscope (TEM). The details of various analyses are shown below.
[Identification of reaction product by XRD]
The sample was subjected to XRD measurement with an X-ray diffraction apparatus (RINT-1200, manufactured by Rigaku Industrial Corporation). As a result, it was found from the diffraction pattern that the oxide layer in the sample was formed of α-alumina. The measurement was carried out under conditions of incident X-ray Cu-Kα radiation, tube voltage 40kV, tube current 40 mA, light reception slit 0.15 mm, and monochrome light reception slit 0.60 mm.

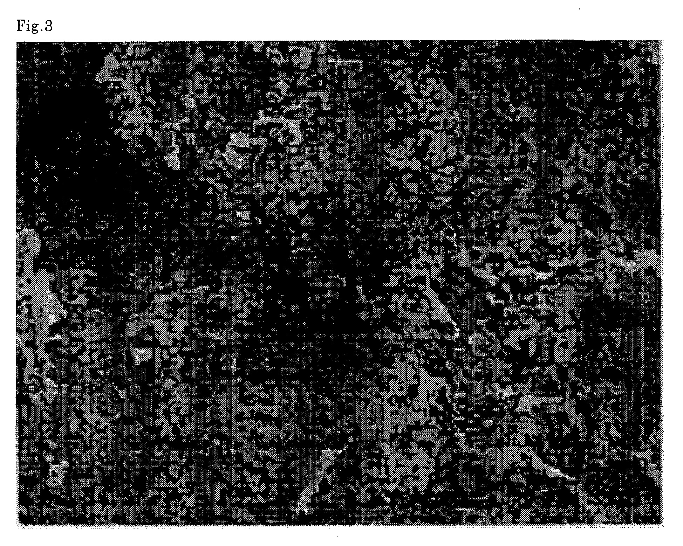

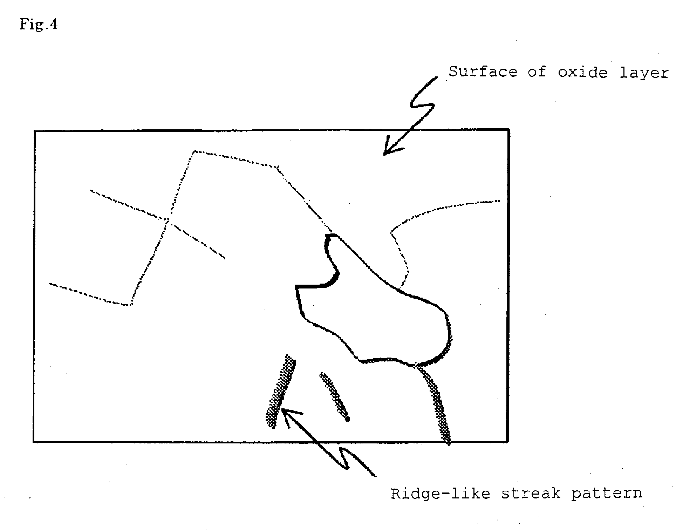

[Observation of surface by SEM]
The sample was cut with a diamond cutter into a size of 5 mm x 5 mm, and the cut sample was fixed onto a sample table for observation with a carbon tape so that the oxidized surface faced upward. This sample was then coated with Pt (platinum) by an ion sputtering apparatus (magnetron sputtering apparatus JUC-5000, manufactured by Japan Electric Optical Laboratory), and the sample surface was observed by FE-SEM (Field Emission-Scanning Electron Microscope JSM-6400, manufactured by Japan Electric Optical Laboratory). The observation was carried out under conditions of acceleration voltage 15 kV, probe current 5 x 10-11 A, emission current 8 µA, and magnification 10,000 times. In this case, 50 visual fields were arbitrarily observed, and these sites were photographed. A typical photograph is shown in Fig. 3, and an illustration thereof is shown in Fig. 4. As shown in Fig. 3, although a ridge-like streak pattern was observed on the surface of the oxide layer, any crack was not observed. Any specific crack was not observed in the arbitrarily selected visual fields (50 visual fields having a radius of 30000 nm) . Further, the thickness of the oxide layer was determined by observation by SEM of a broken surface of the sample and was found to be 900 nm on average.

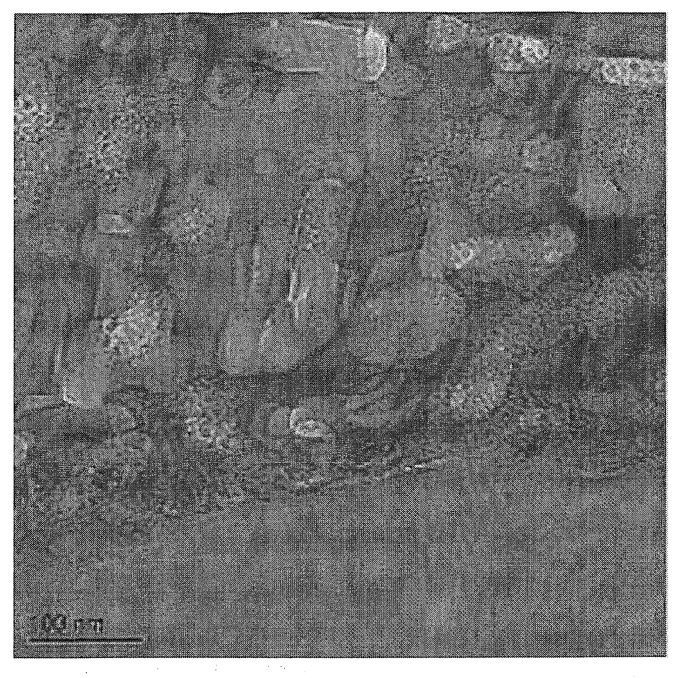

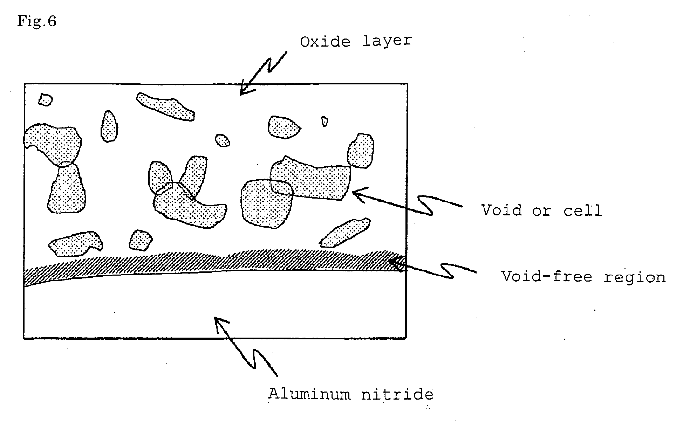

[Observation of cross-section of oxide layer by TEM]
The cross-section of the oxide layer was observed by a field emission-type transmission electron microscope (TECNAI F20) manufactured by FEI under conditions of acceleration voltage 200 kV, spot size 1, gun lens 1, and objective diaphragm 100 µm. A part around the interface of the oxide layer and the nitride ceramic was observed at a magnification of 50000 times, and the site was photographed. A typical photograph is shown in Fig. 5, and an illustration thereof is shown in Fig. 6. As shown in Fig. 5, elliptical cells (or voids) were observed in the oxide layer while a "substantially cell-free region (layer)" having an average thickness of 48 nm was present in a part around the interface between the oxide layer and the underlying material. The sample was prepared by the following method.

[Preparation of sample for observation of cross-section of oxide film by TEM]
The sample was cut into a rectangular parallelepiped having a size of 1 mm in transverse direction and 50 µm in longitudinal direction as viewed from the sample surface with a dicing device (DAD 320) manufactured by DISCO CORPORATION). The rectangular parallelepiped sample was processed by a focused ion beam system (SMI 2200) manufactured by SII NanoTechnology Inc. for cross-sectional observation. In all the cases, the acceleration voltage was 30 kV. The periphery of the rectangular parallelepiped sample was ground while observing the surface of the rectangular parallelepiped sample by a scanning ion microscope (SIM) until the longitudinal size of the sample, which was 50 µm before grinding, became 70 nm. The sample breadth to be ground may be any desired value and was 20 µm in this Example. The sample depth to be ground was set so that the whole oxide layer and a part of the nitride ceramic (about 1 µm) could be observed by observation of the cross-section of the sample by SIM.

[Alkali resistance test]
The sample thus prepared was cut into a predetermined size. The cut sample was covered with a fluororesin seal tape so that a part of the oxide layer was exposed (exposed area S = 10 mm x 10 mm = 100 mm2 = 100 x 10-6 m2). The sample covered with the seal tape was immersed in a 5% aqueous solution of sodium hydroxide at 30°C for 5 hr in such a manner that the part other than the exposed part did not come into contact with the solution (hereinafter referred to as "alkali soaking test"). The weight of the dried sample was measured before and after the soaking. The weight Wb of the dried sample before the soaking was 1376 (mg), and the weight Wa of the dried sample after the soaking was 1375 (mg). The "reduction in dry weight by soaking per unit area" (hereinafter referred to also as "weight reduction") calculated based on these values was 20 (g/m2).

The same test was carried out as a reference experiment for an aluminum nitride substrate not subjected to surface oxidation treatment. As a result, it was found that the weight reduction was 113 (g/m2).
[Tape peel test after heat cycle test]
The sample subjected to the alkali soaking test was subjected to a 1000-cycle test with a thermal shock resistance tester TSV-40S manufactured by ESPEC CORP. in which one cycle consisted of -50°C → 125°C → -50°C (exposure time: 10 min.) (hereinafter referred to as "heat cycle test"). Thereafter, a test was carried out in which, after the application of a circuit tape (PTC 647, manufactured by Teraoka Seisakusho Co., Ltd.) having a size of 18 mm x 30 mm was applied onto the oxide layer in the tested substrate, the tape was peeled off in a vertical direction (hereinafter referred to as "tape peel test"). The peeled surface between the tape and the substrate was observed by a stereomicroscope (SZ-40, manufactured by OLYMPUS CORPORATION) at a magnification of 40 times. As a result, it was found that there was no dropout of the sample structure.

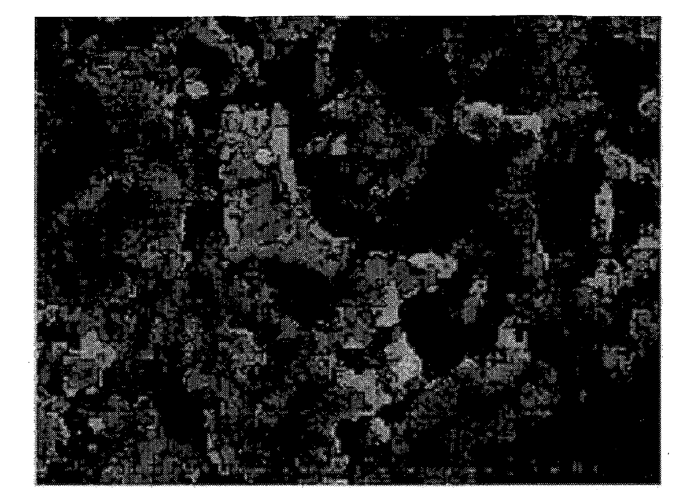

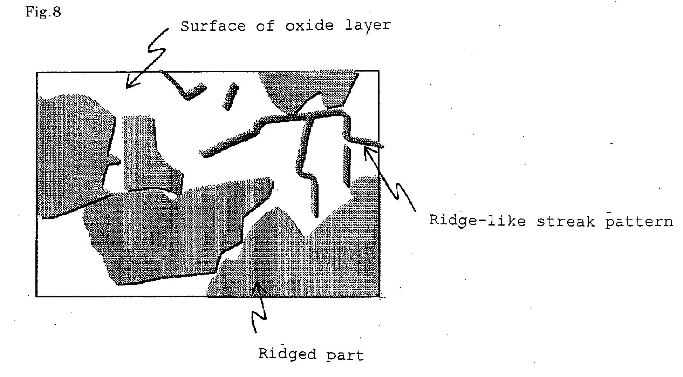

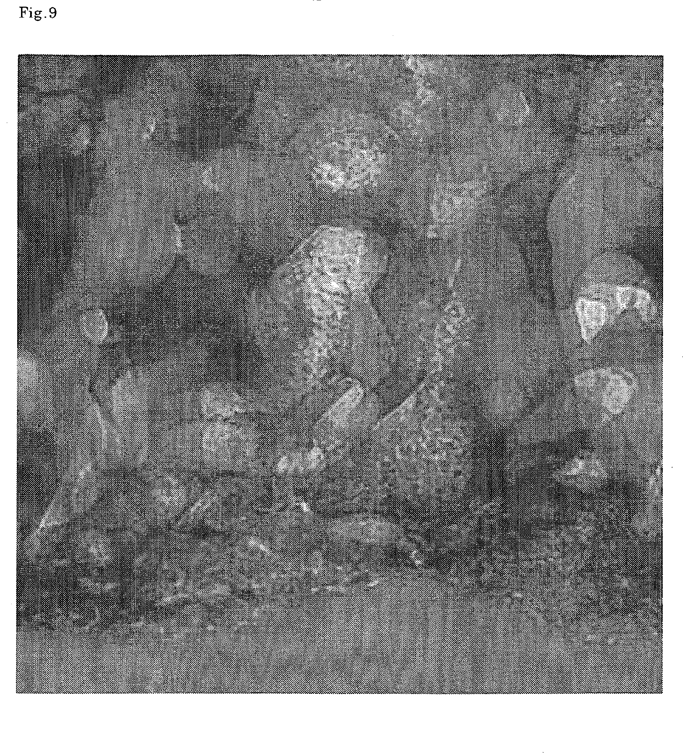

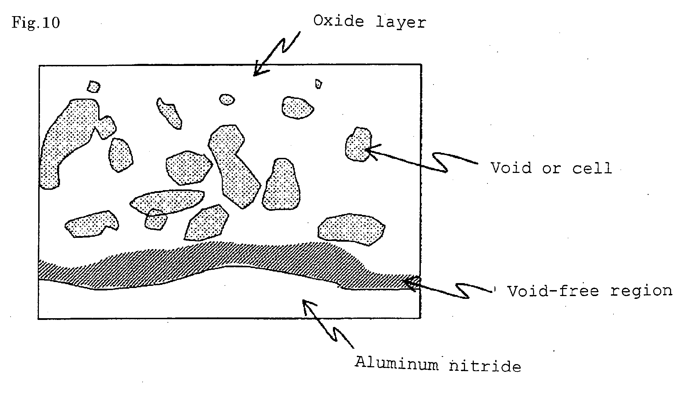

Example 2
A surface oxidized aluminum nitride substrate according to the present invention was prepared by oxidizing an aluminum nitride substrate in a plate form having a size of 50.8 mm in length, 50.8 mm in width, and 0.635 mm in thickness and a surface roughness Ra of not more than 0.05 µm (SH 15, manufactured by TOKUYAMA Corp.) using the same apparatus as in Example 1 in the same manner as in Example 1, except that the holding time was changed to 10 hr. The surface oxidized aluminum nitride substrate (sample) was analyzed by X-ray diffractometry (XRD), a scanning electron microscope (SEM) and a transmission electron microscope (TEM) in the same manner as in Example 1. As a result, it was found from the diffraction pattern obtained in XRD measurement that the oxide layer in the sample was formed of α-alumina. The results of the observation of the surface by SEM are shown in Fig. 7 (photograph) and Fig. 8 (illustration of Fig. 7), and the results of the observation of the cross-section of the oxide layer by TEM are shown in Fig. 9 (photograph) and Fig. 10 (illustration of Fig. 9). As shown in Fig. 7, although a ridge-like streak pattern was observed on the surface of the oxide layer, any crack was not observed. Further, the same observation was carried out for arbitrarily selected visual fields (50 visual fields having a radius of 30000 nm). As a result, any specific crack was observed in none of the visual fields. Further, as shown in Fig. 9, elliptical cells (or voids) were observed in the oxide layer while a "substantially cell-free region (layer)" having an average thickness of 60 nm was present in a part around the interface between the oxide layer and the underlying material. The thickness of the oxide layer was 3600 nm on average. For the prepared sample, an alkali soaking test and a tape peel test after a heat cycle test were carried out in the same manner as in Example 1. As a result, a weight reduction of the substrate in an alkali soaking test was 10 (g/m2), and, in the tape peel test, there was no dropout of the sample structure.

Example 3
An aluminum nitride substrate in a plate form having a size of 50.8 mm in length, 50.8 mm in width, and 0. 635 mm in thickness and a surface roughness Ra of not more than 0.05 µm (SH 15, manufactured by TOKUYAMA Corp.) was heated to 1200°C using the same apparatus as in Example 1 under the same conditions as in Example 1. After it was confirmed that the temperature around the substrate reached 1200°C, the flow of nitrogen gas was stopped, and, instead, an oxidizing gas prepared by mixing nitrogen gas (purity 99.99995%, dew point -80°C) and oxygen gas (purity 99.999%, dew point -80°C) together to give a partial pressure of oxygen gas of 10 kPa was flowed at a flow rate of 1 (l/min.), and this condition was held for 50 hr to oxidize the surface of the aluminum nitride substrate. After the completion of oxidation, the substrate was cooled to room temperature (cooling down rate: 3.3°C/min.) to provide a surface oxidized aluminum nitride substrate according to the present invention.

The surface oxidized aluminum nitride substrate (sample) was analyzed by X-ray diffractometry (XRD), a scanning electron microscope (SEM) and a transmission electron microscope (TEM) in the same manner as in Example 1. As a result, it was found from the diffraction pattern obtained in XRD measurement that the oxide layer in the sample was formed of α-alumina. In surface observation by SEM, although a ridge-like streak pattern was observed on the surface of the oxide layer, any crack was not observed. Further, the same observation was carried out for arbitrarily selected visual fields (50 visual fields having a radius of 30000 nm). As a result, any specific crack was observed in none of the visual fields. In surface observation by TEM, elliptical cells (or voids) were observed in the oxide layer while a "substantially cell-free region (layer)" having an average thickness of 53 nm was present in a part around the interface between the oxide layer and the underlying material. The thickness of the oxide layer was 800 nm on average. For the prepared sample, an alkali soaking test and a tape peel test after a heat cycle test were carried out in the same manner as in Example 1. As a result, a weight reduction of the substrate in an alkali soaking test was 20 (g/m2), and, in the tape peel test, there was no dropout of the sample structure.

Example 4
An aluminum nitride substrate in a plate form having a size of 50.8 mm in length, 50.8 mm in width, and 0. 635 mm in thickness and a surface roughness Ra of not more than 0.05 µm (SH 15, manufactured by TOKUYAMA Corp.) was heated to 1200°C using the same apparatus as in Example 1 under the same conditions as in Example 1. After it was confirmed that the temperature around the substrate reached 1200°C, the flow of nitrogen gas was stopped, and, instead, an oxidizing gas prepared by mixing nitrogen gas (purity 99.99995%, dew point -80°C) and oxygen gas (purity 99.999%, dew point -80°C) together to give a partial pressure of oxygen gas of 10 kPa was flowed at a flow rate of 1 (l/min.), and this condition was held for 10 min. Further, the partial pressure of oxygen gas was increased stepwise to 50 kPa, and this state was held for 5 hr to oxidize the surface of the aluminum nitride substrate. After the completion of oxidation, the substrate was cooled to room temperature (cooling down rate: 3.3°C/min.) to provide a surface oxidized aluminum nitride substrate according to the present invention.

The surface oxidized aluminum nitride substrate (sample) was analyzed by X-ray diffractometry (XRD), a scanning electron microscope (SEM) and a transmission electron microscope (TEM) in the same manner as in Example 1. As a result, it was found from the diffraction pattern obtained in XRD measurement that the oxide layer in the sample was formed of α-alumina. In surface observation by SEM, although a ridge-like streak pattern was observed on the surface of the oxide layer, any crack was not observed. Further, the same observation was carried out for arbitrarily selected visual fields (50 visual fields having a radius of 30000 nm). As a result, any specific crack was observed in none of the visual fields. In surface observation by TEM, elliptical cells (or voids) were observed in the oxide layer while a "substantially cell-free region (layer)" having an average thickness of 47 nm was present in a part around the interface between the oxide layer and the underlying material. The thickness of the oxide layer was 2500 nm on average. For the prepared sample, an alkali soaking test and a tape peel test after a heat cycle test were carried out in the same manner as in Example 1. As a result, a weight reduction of the substrate in an alkali soaking test was 20 (g/m2), and, in the tape peel test, there was no dropout of the sample structure.

Example 5
An aluminum nitride substrate in a plate form having a size of 50. 8 mm in length, 50.8 mm in width, and 0.635 mm in thickness and a surface roughness Ra of not more than 0. 05 µm (SH 15, manufactured by TOKUYAMA Corp.) was heated to 1200°C using the same apparatus as in Example 1 under the same conditions as in Example 1. After it was confirmed that the temperature around the substrate reached 1200°C, the flow of nitrogen gas was stopped, and, instead, an oxidizing gas prepared by mixing nitrogen gas (purity 99.99995%, dew point -80°C) and oxygen gas (purity 99.999%, dew point -80°C) together to give a partial pressure of oxygen gas of 10 kPa was flowed at a flow rate of 1 (l/min.), and this condition was held for 10 min. Thereafter, the gas was changed to pure oxygen gas, and the system was held in this state for 5 hr to oxidize the surface of the aluminum nitride substrate. After the completion of oxidation, the substrate was cooled to room temperature (cooling down rate: 3.3°C/min.) to provide a surface oxidized aluminum nitride substrate according to the present invention.

The surface oxidized aluminum nitride substrate (sample) was analyzed by X-ray diffractometry (XRD), a scanning electron microscope (SEM) and a transmission electron microscope (TEM) in the same manner as in Example 1. As a result, it was found from the diffraction pattern obtained in XRD measurement that the oxide layer in the sample was formed of α-alumina. In surface observation by SEM, although a ridge-like streak pattern was observed on the surface of the oxide layer, any crack was not observed. Further, the same observation was carried out for arbitrarily selected visual fields (50 visual fields having a radius of 30000 nm). As a result, any specific crack was observed in none of the visual fields. In surface observation by TEM, elliptical cells (or voids) were observed in the oxide layer while a "substantially cell-free region (layer)" having an average thickness of 49 nm was present in a part around the interface between the oxide layer and the underlying material. The thickness of the oxide layer was 3200 nm on average. For the prepared sample, an alkali soaking test and a tape peel test after a heat cycle test were carried out in the same manner as in Example 1. As a result, a weight reduction of the substrate in an alkali soaking test was 10 (g/m2), and, in the tape peel test, there was no dropout of the sample structure.

Example 7
A silicon nitride substrate in a plate form having a size of 25.4 mm in length, 25.4 mm in width, and 0.635 mm in thickness and having a surface roughness Ra of not more than 0.1 µm (Denka SN Plate, manufactured by Denki Kagaku Kogyo K.K.) was oxidized at 1400°C for 24 hr using the same apparatus as in Example 1 to prepare a surface oxidized silicon nitride substrate according to the present invention. In this case, at the same time as the start of the temperature raising, gas discharged from the furnace was analyzed with the same apparatus as in Example 1 for components over time. As a result, during temperature raising, any component other than nitrogen was not detected in any temperature region. When 10 min. elapsed from the start of flow of oxygen into the furnace, the waste gas was analyzed. As a result, in addition to oxygen as the flow gas, nitrogen considered to have been produced in the reaction process was detected. The height of the nitrogen peak became the highest value after the start of oxygen flow and somewhat reduced with the elapse of the temperature holding time.

For the surface oxidized silicon nitride substrate (sample), XRD measurement was carried out using the same apparatus as in Example 1 under the same measuring conditions as in Example 1. It was confirmed from the diffraction pattern obtained by XRD measurement that the oxide layer in the sample was formed of cristobalite. The surface of the sample was observed by SEM in the same apparatus, sample preparation method, and observation conditions as in Example 1. As a result, it was found that, in arbitrarily selected 50 visual fields, there was no specific crack, and the oxide layer was very dense. Further, the cross-section of the sample oxide layer was observed by TEM in the same apparatus, sample preparation method and observation conditions as in Example 1. As a result, it was found that an about 40 nm-thick void-free region was present around the interface of the silicon nitride and the oxide layer.

Comparative Examples 1 and 2 (Examples of conventional oxidation)
An aluminum nitride substrate in a plate form having a size of 50.8 mm in length, 50.8 mm in width, and 0. 635 mm in thickness and a surface roughness Ra of not more than 0. 05 µm (SH 15, manufactured by TOKUYAMA Corp.) was introduced into a high-temperature atmosphere furnace comprising a mulite ceramic having an inner diameter of 75 mm and a length of 1100 mm as a furnace tube (SUPER BURN rebuilt type, manufactured by MOTOYAMA Co., Ltd.). The furnace was heated to 1200°C (heating up rate: 3.3°C/min.), under the flow of dry air into the furnace at a flow rate of 2 (l/min.). After the temperature around the substrate was confirmed to reach 1200°C, this state was held for one hr to oxidize the surface of the aluminum nitride substrate. After the completion of oxidation, the substrate was cooled to room temperature (cooling down rate: 3.3°C/min.) to provide a surface oxidized aluminum nitride substrate (Comparative Example 1). Further, a surface oxidized aluminum nitride substrate was produced by oxidation in quite the same manner as in Comparative Example 1, except that the holding time was changed to 10 hr (Comparative Example 2).

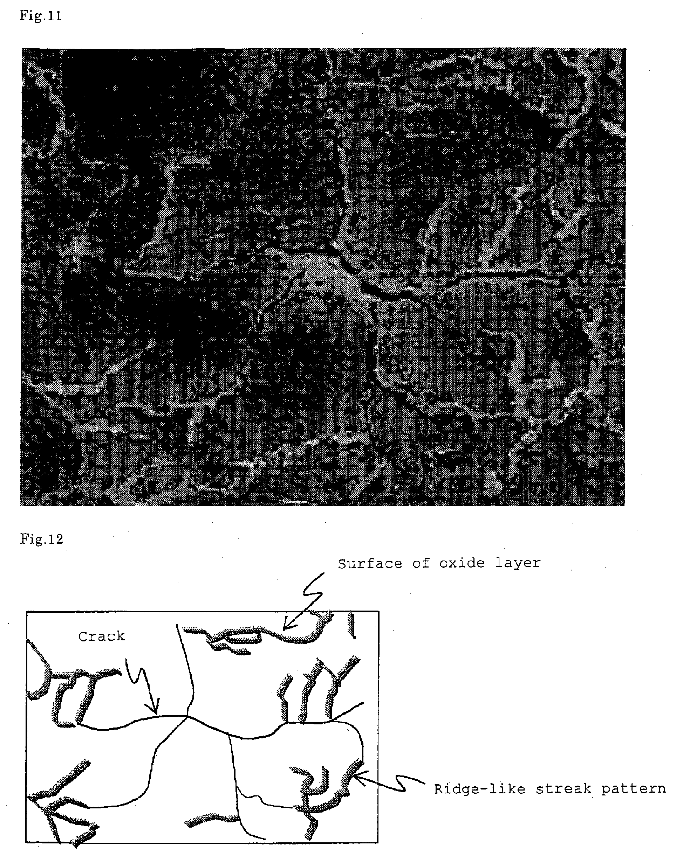

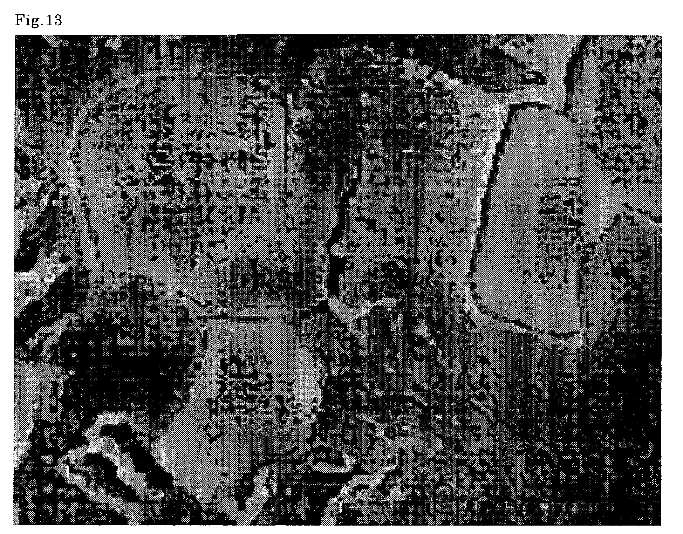

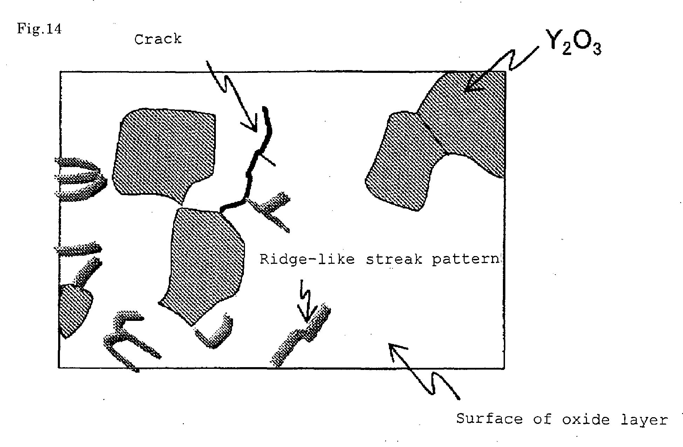

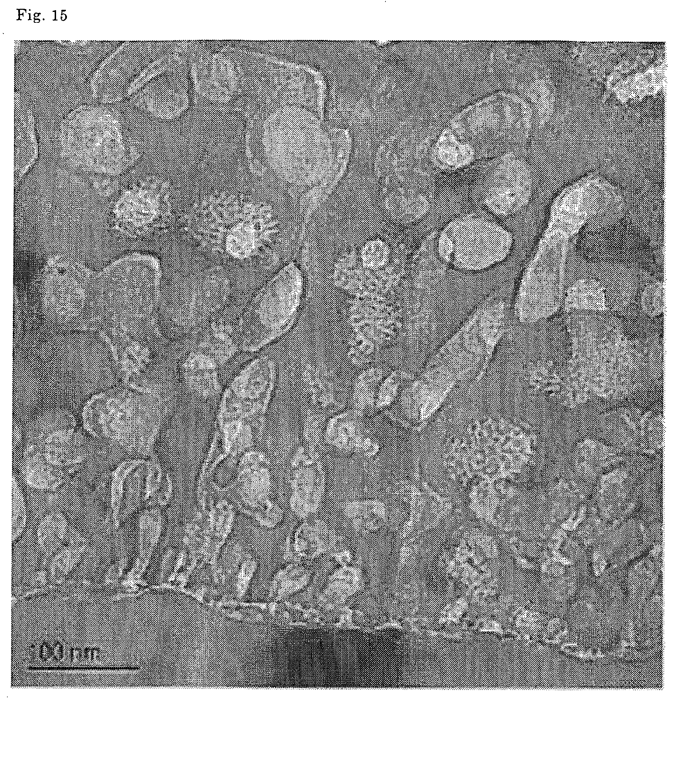

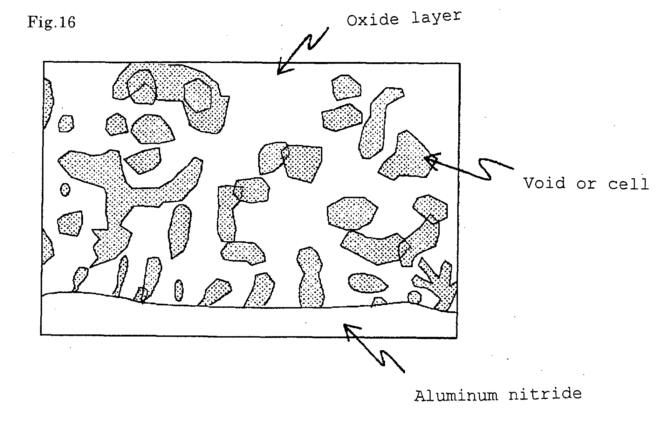

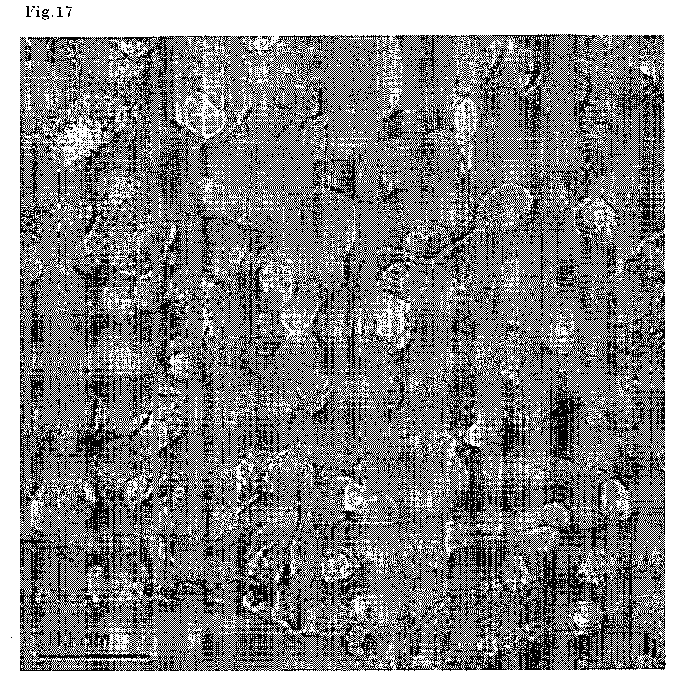

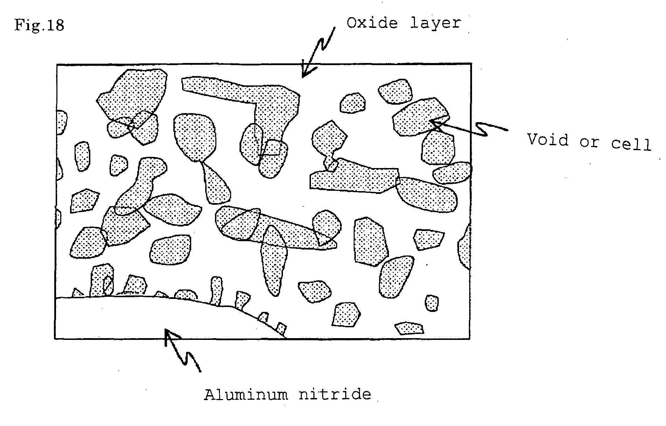

The surface oxidized aluminum nitride substrate (sample) was analyzed by X-ray diffractometry (XRD), a scanning electron microscope (SEM) and a transmission electron microscope (TEM) in the same manner as in Example 1. As a result, it was found from the diffraction pattern obtained in XRD measurement that, for all the samples, the oxide layer was formed of α-alumina. The thickness of the oxide layer was 1500 nm on average for the sample of Comparative Example 1 and was 18000 nm on average for the sample of Comparative Example 2. The results of the observation of the surface of the sample of Comparative Example 1 by SEM are shown in Fig. 11 (photograph) and Fig. 12 (illustration of Fig. 11), and the results of the observation of the surface of the sample of Comparative Example 2 by SEM are shown in Fig. 13 (photograph) and Fig. 14 (illustration of Fig. 13). As shown in Figs. 11 and 13, for both the samples, in addition to a ridge-like streak pattern a specific crack was observed on the surface of the oxide layer. For cracks present on the surface of the oxide layer in each sample, w, l and w/l in crack units having the largest w/l value were determined based on the SEM photograph and were found to be w = 120 nm, l = 880 nm, and w/l = 0.14 for the sample of Comparative Example 1 and were found to be w = 140 nm, l = 760 nm, and w/l = 0.18 for the sample of Comparative Example 2. Further, the same observation was carried out for arbitrarily selected 50 visual fields (visual fields having a radius of 30000 nm). As a result, the number of observed specific cracks was 35 in total for Comparative Example 1 and 38 in total for Comparative Example 2. The results of the observation of the surface of the sample of Comparative Example 1 by TEM are shown in Fig. 15 (photograph) and Fig. 16 (illustration of Fig. 15), and the results of the observation of the surface of the sample of Comparative Example 2 by TEM are shown in Fig. 17 (photograph) and Fig. 18 (illustration of Fig. 17). As shown in Figs. 15 and 17, elliptical cells (or voids) were observed in all the oxide layers. Further, unlike Examples 1 and 2, for all the samples, cells were also observed in a part around the interface between the oxide layer and the underlying material.

For the prepared sample, an alkali soaking test and a tape peel test after a heat cycle test were carried out in the same manner as in Example 1. As a result, a weight reduction of the sample in an alkali soaking test was 103 (g/m2) in Comparative Example 1 and was 85 (g/m2) in Comparative Example 2, and, in the tape peel test, in all the cases, there was dropouts of the sample structure.
Comparative Example 3 (Example of novel oxidation process without degassing treatment)
An aluminum nitride substrate in a plate form having a size of 50.8 mm in length, 50.8 mm in width, and 0.635 mm in thickness and a surface roughness Ra of not more than 0.05 µm (SH 15, manufactured by TOKUYAMA Corp.) was introduced into a high-temperature atmosphere furnace comprising a mulite ceramic having an inner diameter of 75 mm and a length of 1100 mm as a furnace tube (SUPER BURN rebuilt type, manufactured by MOTOYAMA Co., Ltd.). The furnace was heated to 1200°C (heating up rate: 3.3°C/min.) under the flow of nitrogen gas (purity 99.99995%, dew point -80°C) into the furnace at a flow rate of 2 (l/min.). After it was confirmed that the temperature around the substrate reached 1200°C, the flow of nitrogen gas was stopped, and, instead, oxygen gas (purity 99.999%, dew point -80°C) was flowed at a flow rate of 1 (l/min.), and this condition was held for one hr to oxidize the surface of the aluminum nitride substrate. After the completion of oxidation, the substrate was cooled to room temperature (cooling down rate: 3.3°C/min.) to provide a surface oxidized aluminum nitride substrate according to the present invention.

At the same time as the start of the temperature raising, gas discharged from the furnace was introduced into a gas chromatograph (personal gas chromatograph GC-8A, manufactured by Shimadzu Seisakusho Ltd.) and was analyzed for components over time. During temperature raising, very small amounts of oxygen and water in addition to nitrogen were detected. The amount of oxygen and the amount of water contained in gas discharged when the substrate temperature reached 300°C, were qualitatively determined using a separately prepared calibration curve. As a result, the concentration of oxygen and the concentration of water were 1.2 mmol/m3 (0.0027 vol.%) and 1.0 mmol/m3 (0.0022 vol.%), respectively. It is considered that, since the sum of both the concentrations exceeded 0.5 mmol/m3, cells (or voids) were produced in a part around the interface of the oxide layer and the underlying material. Further, when 10 min elapsed from the start of flow of oxygen into the furnace, the waste gas was analyzed. As a result, in addition to oxygen as the flow gas, nitrogen considered to have been produced in the reaction process was detected. The height of the nitrogen peak became the highest value after the start of oxygen flow and somewhat reduced with the elapse of the temperature holding time.

The surface oxidized aluminum nitride substrate (sample) was analyzed by X-ray diffractometry (XRD), a scanning electron microscope (SEM) and a transmission electron microscope (TEM) in the same manner as in Example 1. As a result, it was found from the diffraction pattern obtained in XRD measurement that, for all the samples, the oxide layer was formed of α-alumina. The sample surface was observed by SEM. As a result, it was found that there was no specific crack, and the oxide layer was very dense. Further, the cross-section of the sample oxide layer was observed by TEM. As a result, it was found that voids or cells were present over the whole oxide layer. That is, the percentage cell of the oxide layer in a region having a thickness of not more than 20 nm from the interface of the oxide layer and the aluminum nitride layer was 10%.

For the prepared sample, an alkali soaking test and a tape peel test after a heat cycle test were carried out in the same manner as in Example 1. As a result, a weight reduction of the sample in an alkali soaking test was 30 (g/m2), and, in the tape peel test, there was dropout of the sample structure.
Comparative Example 4 (Example of novel oxidization process in which no degassing treatment is carried out and the partial pressure of oxygen in an initial period of contact is outside the range specified in the present invention)
An aluminum nitride substrate in a plate form having a size of 50.8 mm in length, 50.8 mm in width, and 0.635 mm in thickness and a surface roughness Ra of not more than 0.05 µm (SH 15, manufactured by TOKUYAMA Corp.) was heated to 1200°C (heating up rate: 3.3°C/min.) under the flow of nitrogen gas (purity 99.99995%, dew point -80°C) at a flow rate of 2 (l/min.) without degassing treatment using the same apparatus as in Example 1. After it was confirmed that the temperature around the substrate reached 1200°C, the flow of nitrogen gas was stopped. The inside of the furnace was evacuated by a rotary vacuum pump to not more than 50 Pa. Thereafter, the pressure in the inside of the furnace was rapidly increased by oxygen gas (purity 99.999%, dew point -80°C) to the atmospheric pressure while replacing the atmosphere within the furnace by the oxygen gas, and the oxygen gas was flow into the furnace at a flow rate of 2 (l/min.), and this condition was held for 5 hr to oxidize the surface of the aluminum nitride substrate. After the completion of oxidation, the substrate was cooled to room temperature (cooling down rate: 3.3°C/min.) to provide a surface oxidized aluminum nitride substrate.

The surface oxidized aluminum nitride substrate (sample) was analyzed by X-ray diffractometry (XRD), a scanning electron microscope (SEM) and a transmission electron microscope (TEM) in the same manner as in Example 1. As a result, it was found from a diffraction pattern provided by XRD measurement that, for all the samples, the oxide layer was formed of α-alumina. Further, the oxide layer had a thickness of 3500 nm on average. The surface observation by SEM revealed that not only a ridge-like streak pattern but also nonspecific cracks were observed on the surface of the oxide layer. Further, the observation of the cross-section of the sample by TEM revealed that elliptical cells (or voids) were present in all the oxide layers. Further, unlike Examples 1, 2, and 3, cells were also observed in a part around the interface of the oxide layer and the underlying material. For the prepared sample, an alkali immersion test and a tape peel test after a heat cycle test were carried out in the same manner as in Example 1. As a result, a weight reduction of the sample in an alkali immersion test was 60 (g/m2), and, in the tape peel test, there was dropout of the sample structure.

Comparative Examples 5 and 6 (Examples of novel oxidation process in which the partial pressure of oxygen in the initial period of contact is outside the scope of the present invention)
An aluminum nitride substrate in a plate form having a size of 50.8 mm in length, 50.8 mm in width, and 0.635 mm in thickness and a surface roughness Ra of not more than 0.05 µm (SH 15, manufactured by TOKUYAMA Corp.) was heated to 1200°C using the same apparatus as in Example 1 under the same conditions as in Example 1. After it was confirmed that the temperature around the substrate reached 1200°C, the flow of nitrogen gas was stopped. The inside of the furnace was evacuated by a rotary vacuum pump to not more than 50 Pa. Thereafter, the pressure in the inside of the furnace was rapidly increased by oxygen gas (purity 99.999%, dew point -80°C) to the atmospheric pressure while replacing the atmosphere within the furnace by the oxygen gas, and the oxygen gas was flow into the furnace at a flow rate of 2 (l/min.), and this condition was held for 5 hr to oxidize the surface of the aluminum nitride substrate. After the completion of oxidation, the substrate was cooled to room temperature (cooling down rate: 3.3°C/min.) to provide a surface oxidized aluminum nitride substrate (Example 5). Alternatively, a surface oxidized aluminum nitride substrate was produced in quite the same manner as in Comparative Example 5, except that the increase in pressure was carried out using an oxidizing gas prepared by mixing nitrogen gas (purity 99.99995%, dew point -80°C) and oxygen gas (purity 99.999%, dew point -80°C) together to give a partial pressure of oxygen gas of 50 kPa (Comparative Example 6).

The surface oxidized aluminum nitride substrate (sample) was analyzed by X-ray diffractometry (XRD), a scanning electron microscope (SEM) and a transmission electron microscope (TEM) in the same manner as in Example 1. As a result, it was found from a diffraction pattern provided by XRD measurement that, for all the samples, the oxide layer was formed of α-alumina. The thickness of the oxide layer was 3100 nm on average for the sample of Comparative Example 5 and was 2800 nm on average for the sample of Comparative Example 6. The surface observation by SEM revealed that, for both the samples, not only a ridge-like streak pattern but also nonspecific cracks were observed on the surface of the oxide layer. Further, the observation of the cross-section of the sample by TEM revealed that elliptical cells (or voids) were present in all the oxide layers. Further, unlike Examples 1, 2, and 3, in all the sample, cells were also observed in a part around the interface of the oxide layer and the underlying material. For the prepared sample, an alkali immersion test and a tape peel test were carried out in the same manner as in Example 1. As a result, a weight reduction of the sample in an alkali immersion test was 50 (g/m2) for Comparative Example 5 and was 40 (g/m2) for Comparative Example 6, and, in the tape peel test, there was dropout of the sample structure.

Example 8
A composition comprising 100 parts by weight (H grade, manufactured by TOKUYAMA Corp.) of aluminum nitride powder, 5 parts by weight of a fine powder of yttrium oxide as a sintering aid, and 4 parts by weight of methyl acrylate as an organic binder was uniaxially pressed at a pressure of 500 kg/cm2 to give a green body having size of 360 mm in diameter and 16 mm in thickness.

The green body thus obtained was degreased to remove the organic binder, and the degreased body was placed in a hermetical sealing-type firing vessel made of boron nitride and was fired in a nitrogen atmosphere at a temperature of 1850°C to give a dense sintered aluminum nitride having a relative density of not less than 98% and 177 W/m·K.
The thermal conductivity of the sintered aluminum nitride was measured with a thermal constant measuring apparatus PS-7 manufactured by Rigaku Industrial Corporation by a laser flash method. The thickness was corrected using a calibration curve.

The sintered aluminum nitride thus obtained was fabricated into a circular aluminum nitride susceptor (a wafer holder) having a size of 160 mm in diameter and 5 mm in thickness and a surface roughness of Ra was not more than 0.05 µm for a wafer mounting surface and Ra = 0.8 µm for the other fabricated surface and having three pinholes located on the periphery.
This susceptor was introduced into a high-temperature atmosphere furnace comprising a mulite ceramic having an inner diameter of 200 mm and a length of 1100 mm as a furnace tube so that the wafer mounting surface faced upward. The inside of the furnace was evacuated by a rotary vacuum pump to not more than 50 Pa. Thereafter, the atmosphere in the evacuated furnace was replaced by nitrogen gas (purity 99.99995%, dew point -80°C) by pressure increase, and the furnace was heated to 1200°C (heating up rate: 3.3°C/min.) under nitrogen flow at a flow rate of 2 (l/min.). After the temperature around the substrate was confirmed to reach 1200°C, the nitrogen gas flow was stopped. Next, oxygen gas (purity 99.999%, dew point -80°C) was flowed at a flow rate of 1 (1/min.), and this condition was held for one hr to oxidize' the surface of the susceptor. After the completion of oxidation, the substrate was cooled to room temperature (cooling down rate: 3.3°C/min.) to provide a surface oxidized aluminum nitride susceptor according to the present invention.

At the same time as the start of the temperature raising, gas discharged from the furnace was introduced into a gas chromatograph (personal gas chromatograph GC-8A, manufactured by Shimadzu Seisakusho Ltd., detector: TCD, column: SUS 3 φ x 2 m, filler: molecular sieve 13 X-S 60/80, manufactured by GL Sciences Inc.) and was analyzed for components over time. As a result, during temperature raising, any component other than nitrogen was not detected in any temperature region. When 10 min elapsed from the start of flow of oxygen into the furnace, the waste gas was analyzed. As a result, in addition to oxygen as the flow gas, nitrogen considered to have been produced in the reaction process was detected. The height of the nitrogen peak became the highest value after the start of oxygen flow and reduced with the elapse of the temperature holding time. The partial pressure of oxygen gas in a portion around the sample 2 min and 3 min after the start of introduction of oxygen was determined from a nitrogen peak reduction pattern and a separately prepared calibration curve. As a result, the partial pressure 2 min after the start of introduction of oxygen and the partial pressure 3 min after the start of introduction of oxygen were 22 kPa and 39 kPa, respectively.

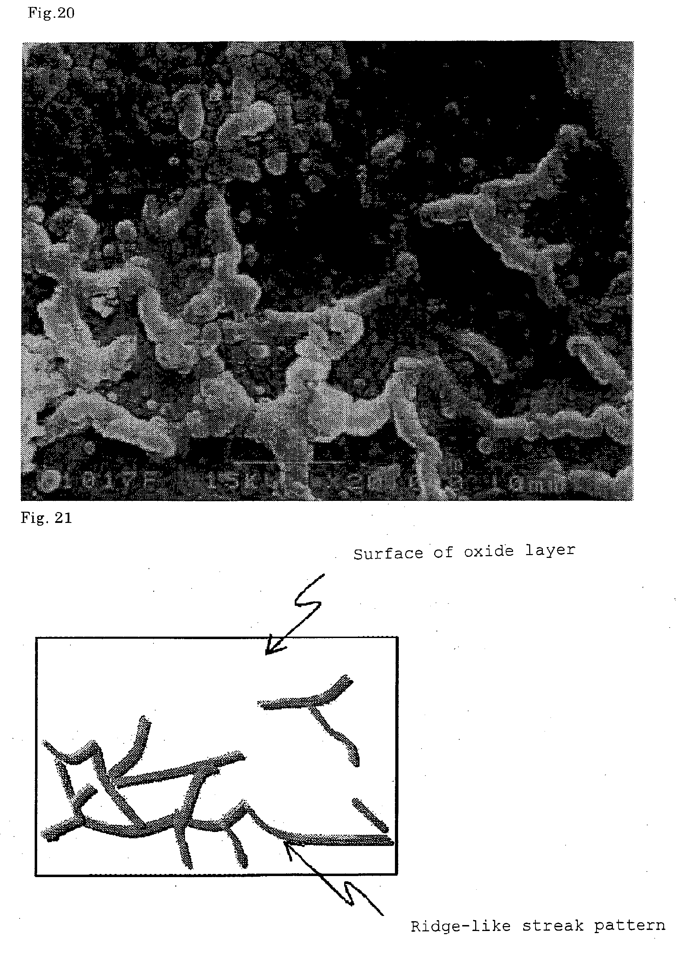

The wafer mounting surface of the surface oxidized aluminum nitride susceptor (sample) was analyzed by X-ray diffractometry (XRD), a scanning electron microscope (SEM) and a transmission electron microscope (TEM).
A typical SEM photograph is shown in Fig. 20, and an illustration thereof is shown in Fig. 21. As shown in Fig. 20, although a ridge-like streak pattern was observed on the surface of the oxide layer, any crack was not observed. Any specific crack was observed in none of the visual fields. Further, the thickness of the oxide layer was determined by observation by SEM of a broken surface of the sample and was found to be 1000 nm on average.

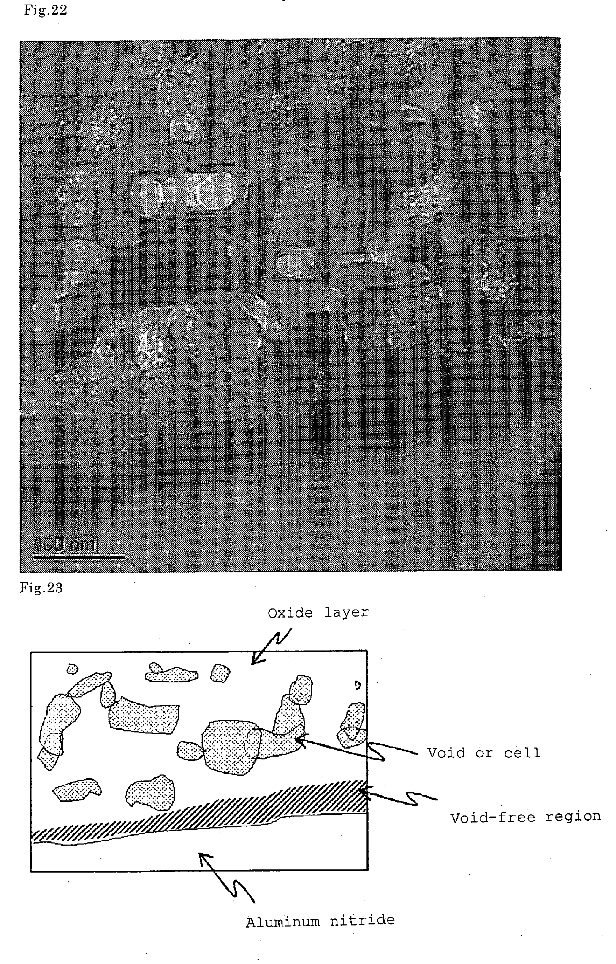

A typical photograph of a part around the interface of the oxide layer and the nitride ceramic is shown in Fig. 22, and an illustration thereof is shown in Fig. 23. As shown in Fig. 22, elliptical cells (or voids) were observed in the oxide layer while a substantially cell-free region (layer) having an average thickness of 43 nm was present in a part around the interface between the oxide layer and the underlying material.
The corrosion resistance of the surface oxidized aluminum nitride susceptor on its wafer mounting surface was evaluated by the following tests I and II.

[Test I for corrosion resistance of sample on its wafer mounting surface]
The susceptor was taken off into a size of 10 mm square and was placed on an electrode within a plasma reactor apparatus so that the wafer mounting surface faced upward. A mixed gas composed of chlorine gas and argon gas at a mixing ratio of 1 : 1 was flowed into the apparatus. The inside of the chamber was held at a pressure of 20 mTorr, and high-frequency plasma was generated at a power of 100 W to perform etching for one hr. The etching rate was determined from a weight difference between before and after the treatment and was found to be not more than 0.2 µm/hr.

After the corrosion resistance test, the state of the sample surface exposed to plasma was observed by SEM. As a result, it was found that the surface was free from partial dropouts and the like of the oxide layer and was in a good state.
[Test II for corrosion resistance of sample on its wafer mounting surface (severe conditions)]
The susceptor was taken off into a size of 10 mm square and was placed on an electrode within a plasma reactor apparatus in such a manner that the wafer mounting surface faced upward and the half face was masked with Kapton tape. A mixed gas composed of chlorine gas and argon gas at a mixing ratio of 20 : 1 was flowed into the apparatus. The inside of the chamber was held at a pressure of 560 mTorr, and high-frequency plasma was generated at a power of 114 W to perform etching for 5 min. After the treatment, the kapton tape on the wafer mounting surface was separated, and the difference in level between the face which had been masked and the etched face was measured and was found to be 0.25 µm

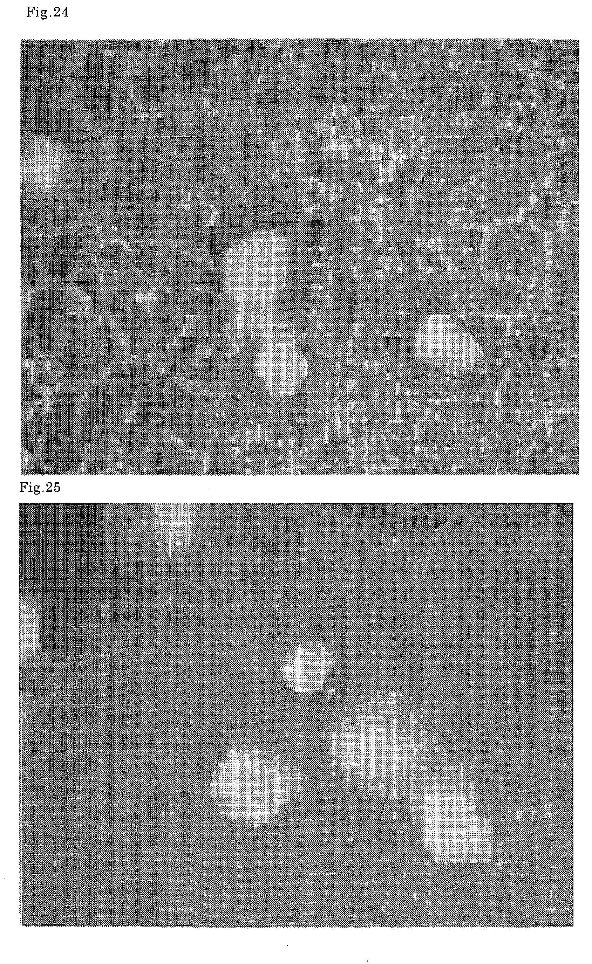

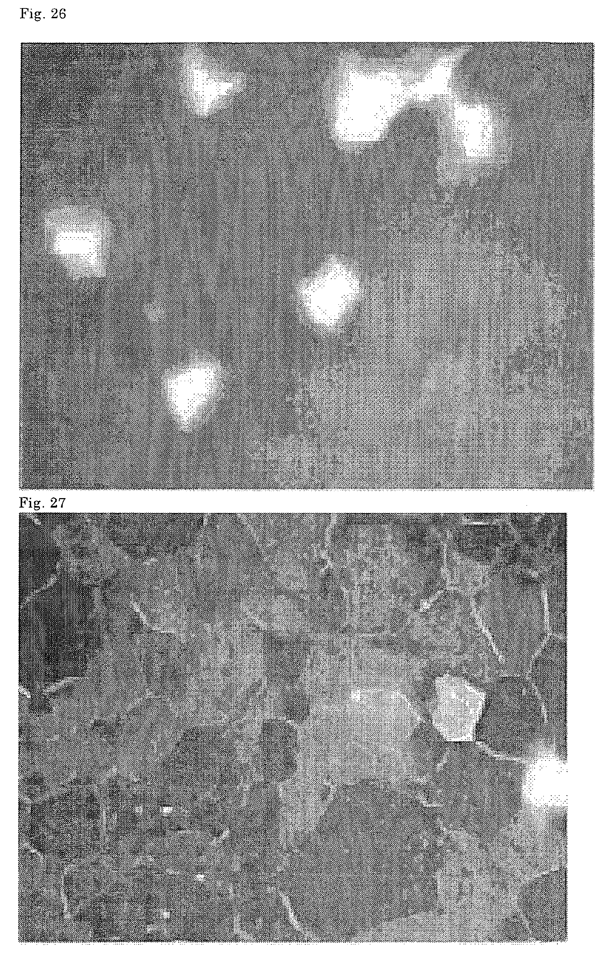

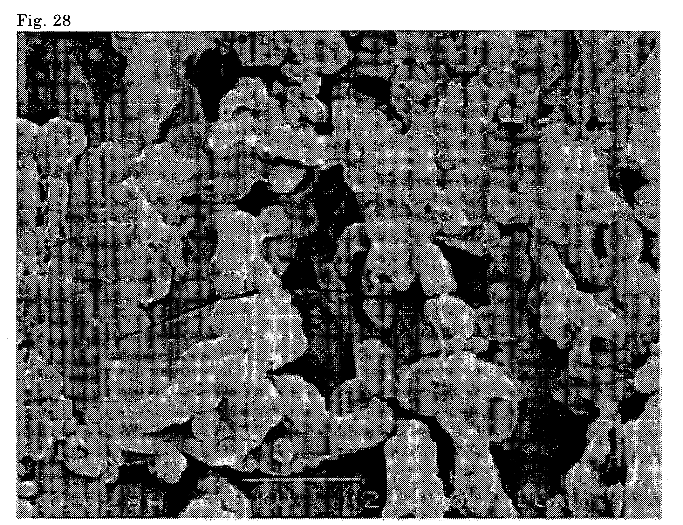

For arbitrarily selected visual fields (40 µm x 30 µm) of the etched face of the susceptor, the surface state was observed by an electron microscope (Hitachi S-2150 scanning electron microscope) to compare the surface state of the part which had been masked with the kapton tape, that is, the surface before the plasma treatment, with the surface exposed to plasma. The observation was carried out under conditions of acceleration voltage 25 kV, emission current 90 µA and magnification 3000 times. A photograph of the surface state before the plasma treatment is shown in Fig. 24, and a photograph of the surface state after the plasma treatment is shown in Fig. 25. An aluminum nitride susceptor, which had been produced by fabrication of a sintered aluminum nitride in the same manner as in this Example except that no surface oxidation was carried out and, thus, no oxide layer was present on the surface, was provided as a control, and the surface state of the control was observed before and after the plasma treatment test by SEM. A photograph of the surface state of the aluminum nitride susceptor free from the oxide layer on its surface before the plasma treatment is shown in Fig. 26, and a photograph of the surface state after the plasma treatment is shown in Fig. 27.

As is apparent from the comparison among the photographs of Figs. 24 to 27, for the aluminum nitride susceptor (object sample) having no oxide layer on its surface, the surface was greatly corroded by the plasma treatment to such a level that the grain boundary of the internal aluminum nitride could be observed. By contrast, the surface oxidized aluminum nitride susceptor produced in this Example was in such a state that, even after the plasma treatment, the ridge-like streak pattern present on the surface of the oxide layer disappeared, and the smoothness of the surface increased and, at the same time, the underlying aluminum nitride material was still satisfactorily protected by the oxide layer.

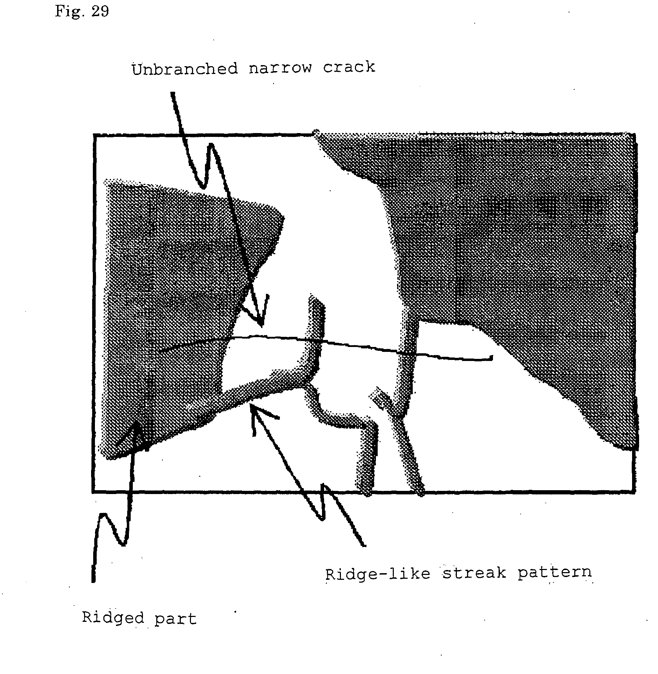

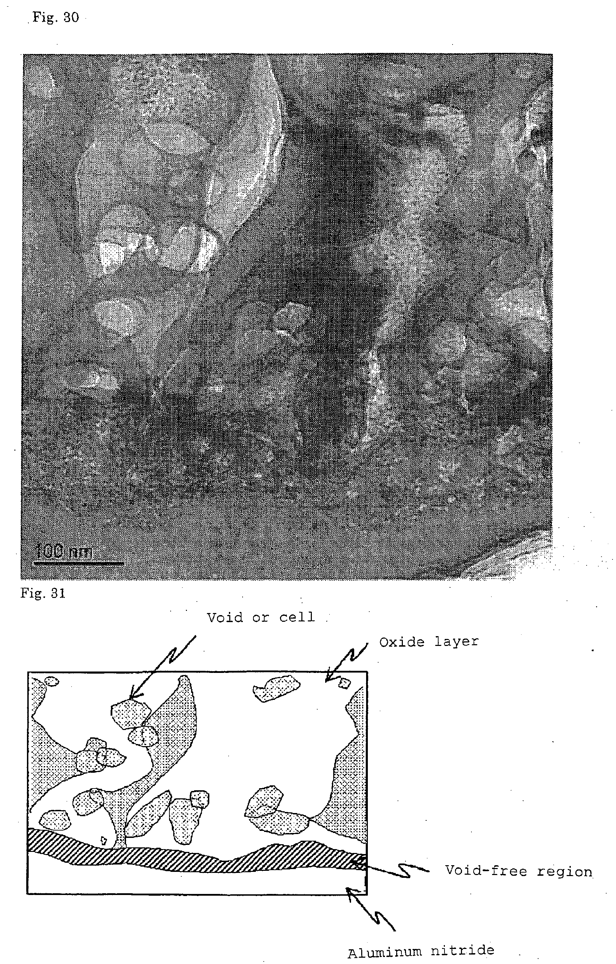

Example 9
A surface oxidized aluminum nitride susceptor according to the present invention was prepared by oxidizing the aluminum nitride susceptor prepared in Example 8 using the same apparatus as in Example 8 in the same manner as in Example 8, except that the holding time was changed to 10 hr.
The wafer mounting surface of the surface oxidized aluminum nitride susceptor (sample) was analyzed by X-ray diffractometry (XRD), a scanning electron microscope (SEM) and a transmission electron microscope (TEM). As a result, it was found from the diffraction pattern obtained in XRD measurement that the oxide layer in the sample was formed of α-alumina. The results of the observation of the surface by SEM are shown in Fig. 28 (photograph) and Fig. 29 (illustration of Fig. 28), and the results of the observation of the cross-section of the oxide layer by TEM are shown in Fig. 30 (photograph) and Fig. 31 (illustration of Fig. 30). As shown in Fig. 28, not only a ridge-like streak pattern but also minor cracks (nonbranched, small-width cracks) not corresponding to specific cracks were observed on the surface of the oxide layer. The same observation was carried out for arbitrarily selected 50 visual fields (visual field having a radius of 30000 nm). As a result, a region where minor cracks not corresponding to the above specific cracks were observed, was located only in a very small part, and any specific crack was observed in none of the visual fields. Further, as shown in Fig. 30, elliptical cells (or voids) were observed in the oxide layer while a "substantially cell-free region (layer)" having an average thickness of 75 nm was present in a part around the interface between the oxide layer and the underlying material. The thickness of the oxide layer was 3200 nm on average.

The corrosion resistance of the wafer mounting surface in the surface oxidized aluminum nitride susceptor thus obtained was evaluated in the same manner as in Example 8.
At the outset, in the corrosion resistance test I, the etching rate was determined from a weight difference between before and after the plasma treatment and was found to be not more than 0.2 µm/hr. Further, after the corrosion resistance test, the state of the sample surface exposed to plasma was observed by SEM. As a result, there was no partial dropout of the oxide layer, and the surface was in a good state.

Further, in the corrosion resistance test II, the difference in level after plasma treatment between the face which had been masked for the plasma treatment and the etched face was 0.25 µm. The surface state before the plasma treatment and the surface state after the plasma treatment were observed by SEM. As a result, as with the surface state in Example 8, the surface state was also good.
Example 10
A composition comprising 100 parts by weight of aluminum nitride powder (H grade, manufactured by TOKUYAMA Corp.), and 4 parts by weight of methyl acrylate as an organic binder was uniaxially pressed at a pressure of 500 kg/cm2 to give a green body having a size of 360 mm in diameter and 16 mm in thickness.

The green body thus obtained was degreased to remove the organic binder, and the degreased body was placed in a hermetical sealing-type firing vessel made of boron nitride and was fired in a nitrogen atmosphere at a temperature of 1875°C to give a dense sintered aluminum nitride having a relative density of not less than 98% and a thermal conductivity of 90 W/m·K.
The sintered aluminum nitride thus obtained was fabricated into a aluminum nitride susceptor (a wafer holder) having the same shape as in Example 4 and having a size of 160 mm in diameter and 5 mm in thickness and a surface roughness of Ra was not more than 0.05 µm for a wafer mounting surface and Ra = 0.8 µm for the other fabricated surface.

A surface oxidized aluminum nitride susceptor according to the present invention was produced by oxidizing this aluminum nitride susceptor using the same apparatus as in Example 8 under the same conditions as in Example 8.
The wafer mounting surface of the surface oxidized aluminum nitride susceptor (sample) was analyzed by X-ray diffractometry (XRD), a scanning electron microscope (SEM) and a transmission electron microscope (TEM).

As a result, it was confirmed from the diffraction pattern obtained by XRD measurement that the oxide layer in the sample was formed of α-alumina. The surface of the sample was observed by SEM in the same apparatus, sample preparation method, and observation conditions as in Example 8. As a result, it was found that, in arbitrarily selected 50 visual fields, there was no specific crack, and the oxide layer was very dense. Further, the cross-section of the sample oxide layer was observed by TEM in the same apparatus, sample preparation method and observation conditions as in Example 4. As a result, it was found that an about 50 nm-thick void-free region was present around the interface of the aluminum nitride interface and the oxide layer.

The corrosion resistance of the wafer mounting surface of the surface oxidized aluminum nitride susceptor thus obtained was evaluated in the same manner as in Example 8.
The etching rate determined from a weight difference between before and after the plasma treatment in the corrosion resistance test I was not more than 0.2 µm/hr. After the corrosion resistance test, the sample surface was observed by SEM. As a result, there was no partial dropout or the like of the oxide layer.

Further, in the corrosion resistance test II, the difference in level after plasma treatment between the face which had been masked for the plasma treatment and the etched face was 0.25 µm. The surface state before the plasma treatment and the surface state after the plasma treatment were observed by SEM. As a result, as with the surface state in Example 8, the surface state was also good.
Example 11
The sintered aluminum nitride produced in Example 8 was fabricated into a circular aluminum nitride window material for high-frequency introduction, having a size of 160 mm in diameter and 5 mm in thickness and a surface roughness of Ra was not more than 0.05 µm for both flat surfaces and Ra = 0.8 µm for the other fabricated surface.

The same apparatus as in Example 8 was provided, and this aluminum nitride window material for high-frequency introduction was fixed within the furnace in such a state that the chamber inner side surface faced upward. In this state, oxidation was carried out in the same manner as in Example 8 to produce a surface oxidized aluminum nitride window material for high-frequency introduction according to the present invention. The chamber inner side surface of the surface oxidized aluminum nitride window for high-frequency introduction (sample) was analyzed by X-ray diffractometry (XRD), a scanning electron microscope (SEM) and a transmission electron microscope (TEM).

As a result, it was confirmed from the diffraction pattern obtained by XRD measurement that the oxide layer in the sample was formed of α-alumina. The surface of the sample was observed by SEM in the same apparatus, sample preparation method, and observation conditions as in Example 8. As a result, it was found that there was no specific crack, and the oxide layer was very dense. Further, the cross-section of the sample oxide layer was observed by TEM in the same apparatus, sample preparation method and observation conditions as in Example 4. As a result, it was found that an about 55 nm-thick void-free region was present around the interface of the aluminum nitride interface and the oxide layer.

The corrosion resistance of the surface oxidized aluminum nitride window material for high-frequency introduction thus obtained was evaluated by a method as described in Example 8. In the tests I and II, the window material was placed on an electrode within a plasma reactor so that the window material on its face exposed to plasma in use faced upward.
At the outset, in the corrosion resistance test I, the etching rate was determined from a weight difference between before and after the plasma treatment and was found to be not more than 0.2 µm/hr. Further, after the corrosion resistance test, the state of the sample surface exposed to plasma was observed by SEM. As a result, there was no partial dropout and the like in the oxide layer.

Further, in the corrosion resistance test II, the difference in level after plasma treatment between the face which had been masked for the plasma treatment and the etched face was 0.25 µm. The surface state before the plasma treatment and the surface state after the plasma treatment were observed by SEM. As a result, as with the surface state in Example 8, the surface state was also good.
Comparative Example 7 (Example of new oxidation process without degassing treatment)
An aluminum nitride susceptor as used in Example 8 was introduced into a high-temperature atmosphere furnace comprising a mulite ceramic having an inner diameter of 200 mm and a length of 1100 mm as a furnace tube so that the wafer mounting surface faced upward. The furnace was heated to 1200°C (heating up rate: 3.3°C/min.) under the flow of nitrogen gas (purity 99.99995%, dew point -80°C) into the furnace at a flow rate of 2 (l/min.). After it was confirmed that the temperature around the susceptor reached 1200°C, the flow of nitrogen gas was stopped, and, next, oxygen gas (purity 99.999%, dew point -80°C) was flowed at a flow rate of 1 (l/min.), and this condition was held for one hr to oxidize the surface of the susceptor. After the completion of oxidation, the substrate was cooled to room temperature (cooling down rate: 3.3°C/min.) to provide a surface oxidized aluminum nitride susceptor according to the present invention.

At the same time as the start of the temperature raising, gas discharged from the furnace was introduced into a gas chromatograph (personal gas chromatograph GC-8A, manufactured by Shimadzu Seisakusho Ltd.) and was analyzed for components over time. During temperature raising, very small amounts of oxygen and water in addition to nitrogen were detected. The amount of oxygen and the amount of water contained in gas discharged when the susceptor temperature reached 1000°C, were qualitatively determined using a separately prepared calibration curve. As a result, the concentration of oxygen and the concentration of water were 1.2 mmol/m3 (0.0027 vol.%) and 1.0 mmol/m3 (0.0022 vol.%), respectively. It is considered that, since the sum of both the concentrations exceeded 0.5 mmol/m3, cells (or voids) were produced in a part around the interface of the oxide layer and the underlying material.

The surface oxidized aluminum nitride susceptor (sample) on its wafer mounting surface was analyzed by X-ray diffractometry (XRD), a scanning electron microscope (SEM) and a transmission electron microscope (TEM) in the same manner as in Example 4 . As a result, it was found from the diffraction pattern obtained in XRD measurement that, for all the samples, the oxide layer was formed of α-alumina. The sample surface was observed by SEM. As a result, it was found that there was no specific crack in arbitrarily selected 50 visual fields, and the oxide layer was very dense. Further, the cross-section of the sample oxide layer was observed by TEM. As a result, it was found that voids or cells were present over the whole oxide layer.

The corrosion resistance of the wafer mounting surface in the surface oxidized aluminum nitride susceptor thus obtained was evaluated in the same manner as in Example 8.
At the outset, in the corrosion resistance test I, the etching rate was determined from a weight difference between before and after the plasma treatment and was found to be not more than 0.2 µm/hr. Further, after the corrosion resistance test, the state of the sample surface exposed to plasma was observed by SEM. As a result, partial dropout of the oxide layer was somewhat observed.

Further, in the corrosion resistance test II, the difference in level after plasma treatment between the face which had been masked for the plasma treatment and the etched face was 0.25 µm. The surface state before the plasma treatment and the surface state after the plasma treatment were observed by SEM. As a result, as with the surface state in Example 8, the surface state was also good.
Comparative Examples 8 and 9
The same aluminum nitride susceptor as used in Example 8 was introduced into a high-temperature atmosphere furnace comprising a mulite ceramic having an inner diameter of 200 mm and a length of 1100 mm as a furnace tube. The furnace was heated to 1200°C (heating up rate: 3.3°C/min.) under the flow of dry air into the furnace at a flow rate of 2 (l/min.). After the temperature around the susceptor was confirmed to reach 1200°C, this state was held for one hr to oxidize the surface of the susceptor. After the completion of oxidation, the substrate was cooled to room temperature (cooling down rate: 3.3°C/min.) to provide a surface oxidized aluminum nitride susceptor (Comparative Example 8). Further, a surface oxidized aluminum nitride susceptor was produced by oxidation in quite the same manner as in Comparative Example 8, except that the holding time was changed to 10 hr (Comparative Example 9).

The wafer mounting surface of the surface oxidized aluminum nitride susceptor (sample) was analyzed by X-ray diffractometry (XRD), a scanning electron microscope (SEM) and a transmission electron microscope (TEM) in the same manner as in Example 8. As a result, it was found from the diffraction pattern obtained in XRD measurement that, for all the samples, the oxide layer was formed of α-alumina. The thickness of the oxide layer was 1400 nm on average for the sample of Comparative Example 8 and was 16000 nm on average for the sample of Comparative Example 9.

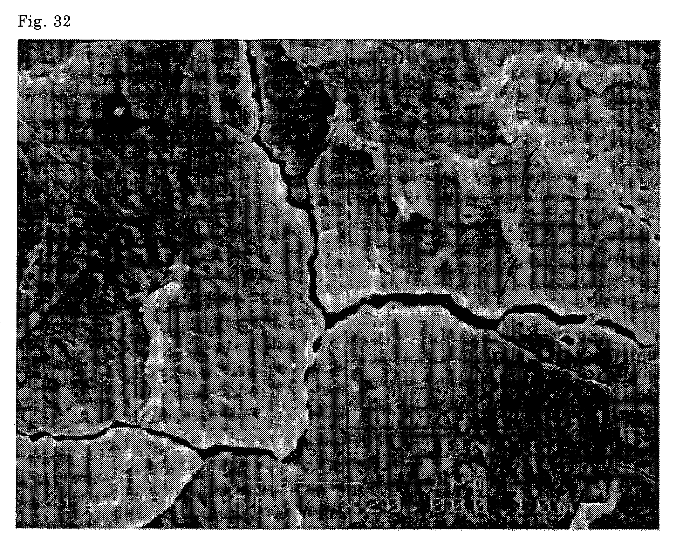

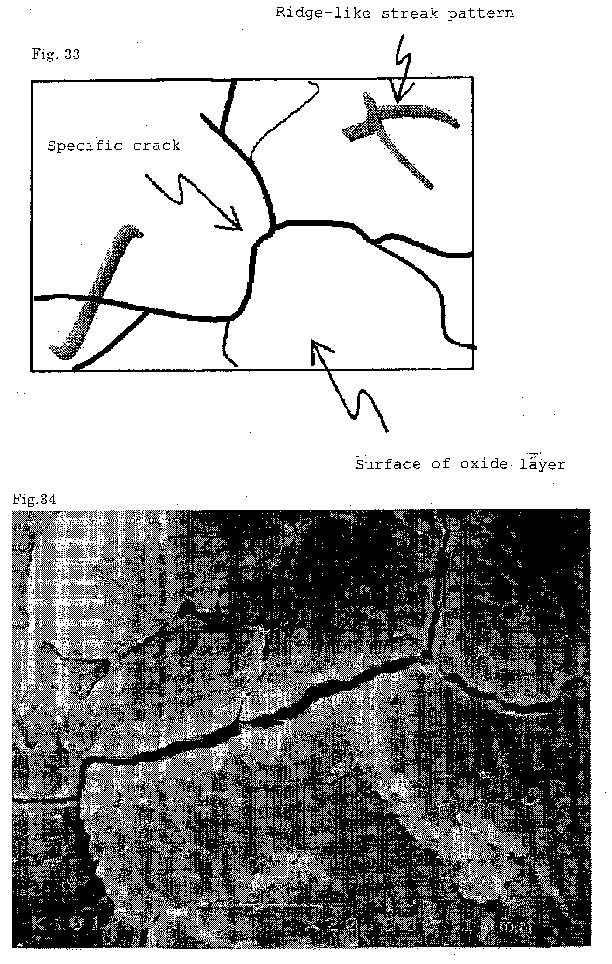

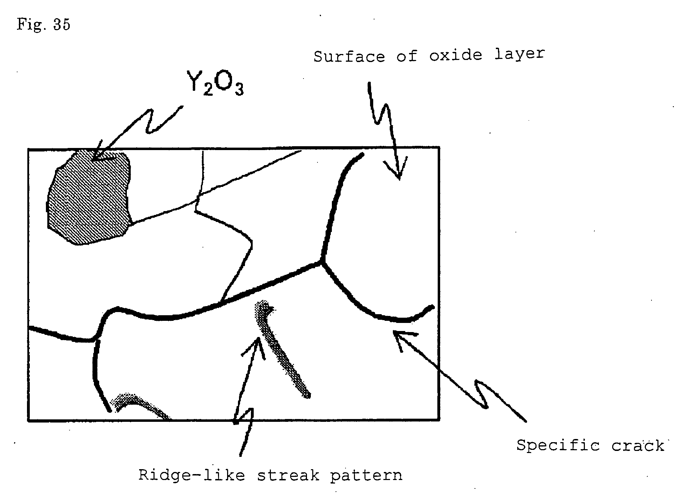

The results of the observation of the surface of the sample of Comparative Example 8 by SEM are shown in Fig. 32 (photograph) and Fig. 33 (illustration of Fig. 32), and the results of the observation of the surface of the sample of Comparative Example 9 by SEM are shown in Fig. 34 (photograph) and Fig. 35 (illustration of Fig. 34). As shown in Figs. 32 and 34, for both the samples, in addition to a ridge-like streak pattern a specific crack was observed on the surface of the oxide layer. For cracks present on the surface of the oxide layer in each sample, w, 1 and w/l in crack units having the largest w/l value were determined based on the SEM photograph and were found to be w = 120 nm, 1 = 2800 nm, and w/l = 0.04 for the sample of Comparative Example 8 and were found to be w = 150 nm, 1 = 3500 nm, and w/l = 0.04 for the sample of Comparative Example 9. Further, the same observation was carried out for arbitrarily selected 50 visual fields (visual fields having a radius of 30000 nm). As a result, the number of observed specific cracks was 33 in total for Comparative Example 8 and 36 in total for Comparative Example 9.

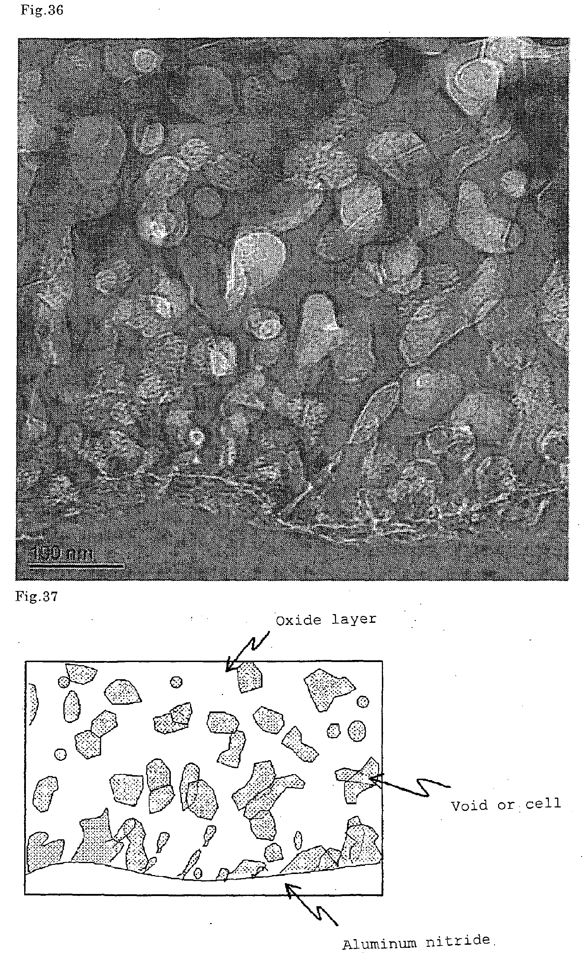

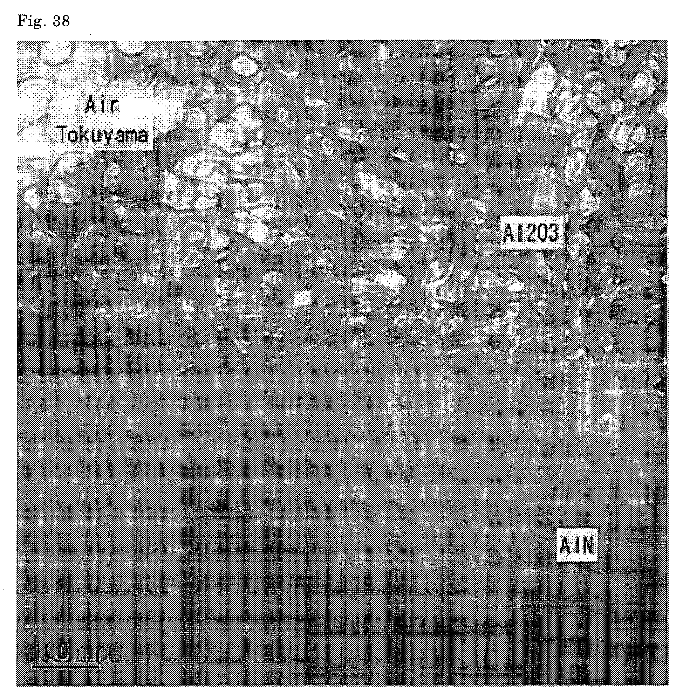

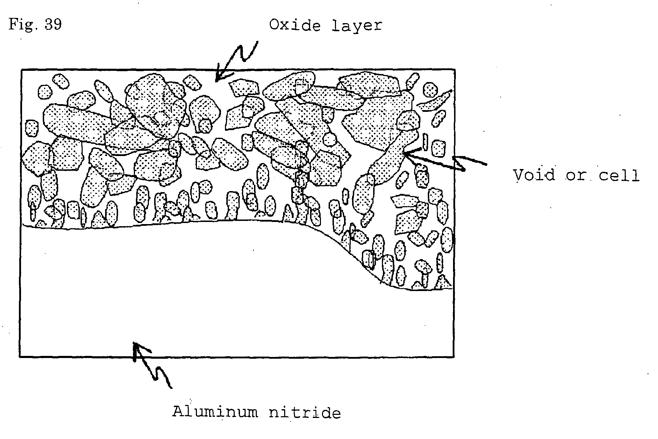

The results of the observation of the cross-section of the sample of Comparative Example 8 by TEM are shown in Fig. 36 (photograph) and Fig. 37 (illustration of Fig. 36), and the results of the observation of the cross-section of the sample of Comparative Example 9 by TEM are shown in Fig. 38 (photograph) and Fig. 39 (illustration of Fig. 38). As shown in Figs. 36 and 38, elliptical cells (or voids) were observed in all the oxide layers. Further, unlike Example 8, for all the samples, cells were also observed in a part around the interface between the oxide layer and the underlying material.

The corrosion resistance of the wafer mounting surface in the surface oxidized aluminum nitride susceptor thus obtained was evaluated in the same manner as in Example 8.
At the outset, in the corrosion resistance test I, the etching rate was determined from a weight difference between before and after the plasma treatment and was found to be 0.6 µm/hr for Comparative Example 8 and 1 µm/hr for Comparative Example 9. Further, after the corrosion resistance test, the state of the sample surface exposed to plasma was observed by SEM. As a result, for both Comparative Examples 8 and 9, there was partial dropout of the oxide layer.

Further, in the corrosion resistance test II, the difference in level after plasma treatment between the face which had been masked for the plasma treatment and the etched face was 0.36 µm for Comparative Example 8 and 0.40 µm for Comparative Example 9.

### INDUSTRIAL APPLICABILITY

According to the method of the present invention, an oxide film having very high quality can be formed on the surface of sinters of non-oxide ceramics, for example, nitride ceramics such as aluminum nitride and silicon nitride, and carbide ceramics such as silicon carbide, and, at the same time, as compared with the oxidation by the conventional method, various effects attained by the formation of an oxide film, for example, improved water resistance and chemical resistance, improved plasma resistance, and improved mechanical strength can be further improved. Further, the reliability and the durability can also be enhanced. In particular, the "sintered non-oxide ceramics having an oxide layer on its surface" produced by the method according to the present invention has such a structural feature that the oxide layer is substantially free from highly branched characteristic cracks observed in the oxide film formed by the conventional method and, at the same time, is substantially free from voids around the interface of the non-oxide ceramics base material and the oxide film. By virtue of this structural feature, the adhesive strength between the non-oxide ceramics base material and the oxide layer is very high, and, thus, the above-described various effects, that is, reliability and durability, can be enhanced.

In the cooling device according to the present invention, despite the fact that the cooling jacket is formed of a non-oxide ceramics having high thermal conductivity, since the cooling jacket in its part which comes into contact with cooling medium is covered with a high-quality oxide layer, there is no fear of causing a deterioration in non-oxide ceramics even when water or an aqueous solution is used as a cooling medium. Further, the oxide layer is in strong adhesion to the underlying non-oxide ceramic. The cooling jacket can be used stably for a long period of time without no particular necessity of strictly controlling the amount of ionization substance contained in the cooling medium.

Despite the fact that the plasma resistant member according to the present invention is formed of a non-oxide ceramics such as aluminum nitride, since the surface is free from cracks, which have a large width and are highly branched, and has high densiness, the plasma resistant member is less likely to be deteriorated even upon exposure to plasma such as halogen-type corrosive gases. That is, the deterioration caused by the surface corrosion upon exposure to the plasma can be significantly reduced. When the member is for constituting a chamber used in the production process of semiconductors or liquid crystals, the generation of particles caused by the corrosion of the surface can be suppressed and, thus, the effect of preventing the contamination of wafers is large.

A change in shape of the member surface caused by the progress of the corrosion can also be suppressed. For example, when the member is a wafer holder for constituting the chamber, the reliability of the wafer holder can be maintained for a long period of time.
Further, the formation of a dense oxide layer on the surface can also improve the homogeneity of thermal conduction into the inside and, at the same time, is also effective in homogenizing heat dissipation and temperature distribution. Furthermore, since the oxide layer adheres strongly to the underlying non-oxide ceramic, the effect can be maintained for a long period of time even under severe service conditions such as a significant temperature change in a service environment.

## Claims

1. A method for producing a non-oxide ceramics having an oxide layer on its surface by oxidizing the surface of a non-oxide ceramics, **characterized in that**
said method comprises the steps of:
(1) providing a non-oxide ceramics;
(2) introducing said non-oxide ceramics into a furnace, then discharging an oxidizing substance adsorbed or sorbed to said non-oxide ceramics or to a material constituting the furnace outside of the furnace, so as to reduce an oxidizing gas content in the atmosphere within the furnace to be not more than 0.5 mmol in terms of total number of moles of the oxidizing gas per m3 of the inside of the furnace;
(3) heating said non-oxide ceramics to a temperature at or above a temperature, which is 300°C below the oxidation start temperature of said non-oxide ceramics, while maintaining the atmosphere in the furnace having an oxidizing gas content of not more than 0.5 mmol in terms of total number of moles of the oxidizing gas per m3 of the inside of the furnace; and
(4) brining the non-oxide ceramics heated in said step (3) into contact with an oxidizing gas and then holding the non-oxide ceramics at a temperature above the oxidation start temperature of said non-oxide ceramics to form an oxide layer on the surface of said non-oxide ceramics, and that
when bringing said non-oxide ceramics into contact with said oxidizing gas in said step (4), after the contact of said non-oxide ceramics and said oxidizing gas, until at least 2 min. elapses after the arrival of the temperature of said non-oxide ceramics at or above the oxidation start temperature thereof, the pressure or partial pressure of the oxidizing gas is maintained at not more than 50 kPa.

2. A non-oxide ceramics having an oxide layer on its surface, **characterized by** comprising a non-oxide ceramics of a nitride or carbide of a metal or semimetal and a 0.1 to 100 µm-thick oxide layer provided on said surface of said non-oxide ceramics, said oxide being an oxide of an element identical to said metal or semimetal element, voids being substantially absent in said oxide layer in its region in a thickness of at least 20 nm from the boundary of said non-oxide ceramics and said oxide layer.

3. The non-oxide ceramics having an oxide layer on its surface according to claim 2, **characterized in that**, when a branched crack is divided into a crack unit located between adjacent branch points and crack units extending from the crack end to the nearest branch point, a branched crack having a crack unit simultaneously having a w value of not less than 20 nm, an l value of not less than 500 nm and a w/l value of not less than 0.02, wherein l (nm) represents the length of each crack unit, and w (nm) represents the maximum width of each crack unit, is substantially absent on the surface of the oxide layer.

4. The non-oxide ceramics having an oxide layer on its surface according to claim 2 or 3, wherein said non-oxide ceramics is comprised of a sintered aluminum nitride, and the oxide layer consists essentially of polycrystalline α-alumina.

5. A non-oxide ceramics having an oxide layer on its surface produced by the method according to claim 1.

6. A cooling device comprising: an exothermic element; a cooling jacket formed of the non-oxide ceramics having an oxide layer on its surface according to any one of claims 2 to 5; and cooling medium feeding means, wherein said exothermic element and the cooling jacket come into thermal contact with each other, a cooling medium is fed from said cooling medium feeding means into said cooling jacket, and an oxide layer is provided on the surface of said cooling jacket at least on its side which comes into contact with said cooling medium.

7. A plasma resistant member comprising the non-oxide ceramics having an oxide layer on its surface according to any one of claims 2 to 5.

8. The plasma resistant member according to claim 7, which is a member for constituting a chamber in a semiconductor or liquid crystal production apparatus comprising a plasma production mechanism.

9. The plasma resistant member according to claim 8, which is a wafer holder.

10. The plasma resistant member according to claim 9, which is a window material for high frequency wave introduction.
